(19) Europäisches Patentamt
European Patent Office
Office européen des brevets

(11) EP 2 519 088 A1

(12) EUROPEAN PATENT APPLICATION
published in accordance with Art. 153(4) EPC

(43) Date of publication:
**31.10.2012 Bulletin 2012/44**

(21) Application number: **10838919.8**

(22) Date of filing: **17.12.2010**

(51) Int Cl.:
***H05K 3/34*** *(2006.01)* ***C09J 9/02*** *(2006.01)*
***H01B 5/02*** *(2006.01)* ***H01L 21/60*** *(2006.01)*
***H01R 11/01*** *(2006.01)* ***H01R 43/00*** *(2006.01)*

(86) International application number:
**PCT/JP2010/007323**

(87) International publication number:
**WO 2011/077679 (30.06.2011 Gazette 2011/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.12.2009 JP 2009292706**

(71) Applicant: **Sumitomo Bakelite Co., Ltd.**
**Shinagawa-ku**
**Tokyo 140-0002 (JP)**

(72) Inventors:
- **CHUMA,Toshiaki**
  **Tokyo 140-0002 (JP)**
- **KAGIMOTO, Tomohiro**
  **Tokyo 140- 0002 (JP)**

(74) Representative: **Vossius, Corinna**
**Dr. Volker Vossius**
**Patent- und Rechtsanwaltskanzlei**
**Geibelstrasse 6**
**81679 München (DE)**

# (54) CONDUCTIVE CONNECTION MATERIAL, ELECTRONIC COMPONENT PRODUCING METHOD, AND ELECTRONIC MEMBER AND ELECTRONIC COMPONENT WITH CONDUCTIVE CONNECTION MATERIAL

(57) Disclosed is a conductive connecting material 30 used to form conductive portions on a plurality of terminals 11 of an electronic member having a substrate 10 and the plurality of terminals 11 provided on the substrate 10, comprising a metal layer 110 and a resin layer 120 having a resin component and a filler, in which the metal layer is aggregated on each of terminals to form the conductive portions on the plurality of terminals by bringing the conductive connecting material into contact with the plurality of terminals and heating the conductive connecting material.

Fig.2

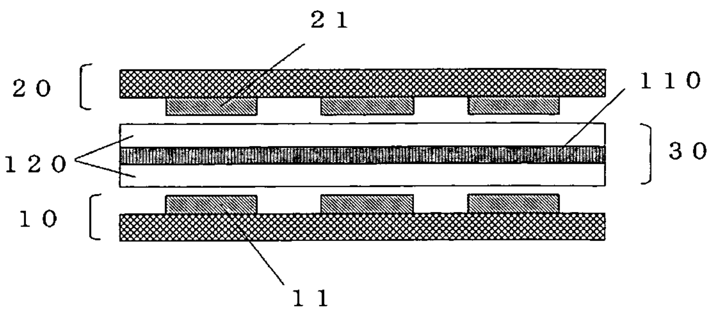


EP 2 519 088 A1

Printed by Jouve, 75001 PARIS (FR)

**Description**

TECHNICAL FIELD

The present invention relates to a conductive connecting material, a method for producing an electronic component, an electronic member with the conductive connecting material and an electronic component.

BACKGROUND ART

In recent years, with the requirements of higher functionality and reduction in a size of electronic devices, the pitch between connecting terminals in an electronic material has been more and more narrowed, and connection between terminals in a fine pitch circuit has also been sophisticated. As a method for connecting terminals, for example, a flip-chip connection technique, in which, when an IC chip is electrically connected to a circuit board, an anisotropic conductive adhesive or anisotropic conductive film is used to connect a plurality of terminals at one time, has been known. Such an anisotropic conductive adhesive or anisotropic conductive film is a film or a paste in which conductive particles are dispersed in an adhesive containing a thermosetting resin as the main component (see, for example, Japanese Unexamined Patent Application Publication No. S 61-276873 (Patent Document 1) and Japanese Unexamined Patent Application Publication No. 2004-260131 (Patent Document 2)). By placing this between electronic members to be connected and performing thermal compression bonding, a plurality of opposed terminals can be connected at one time and the insulation properties between adjacent terminals can be ensured by the resin in the adhesive.
However, in the existing anisotropic conductive adhesive or anisotropic conductive film, it is extremely difficult to control aggregation of conductive particles. Therefore, there are problems such that (1) a part of opposed terminals is not conducted since a conductive particle and a terminal or conductive particles do not sufficiently contact to each other, and (2) conductive particles remain in the resin (insulating areas) positioned in areas other than those between opposed terminals (conductive areas) to cause a leak current and therefore the insulation properties between adjacent terminals cannot be sufficiently ensured in some cases. Therefore, it is difficult to further narrow the pitch between terminals by using conventional anisotropic conductive adhesive or anisotropic conductive film.
Meanwhile, in the production of a connecting terminal on an electrode of an electronic member, conventionally, a solder paste is printed onto a substrate having a metal pad and melted with heat using a solder reflow apparatus to form a connecting terminal. However, in this method, when the pitch between connecting terminals is narrow, the cost of a mask used for printing the solder paste is increased. Furthermore, when the size of the connecting terminal is extremely small, printing of the solder paste may be impossible in some cases. There is also a method for producing a connecting terminal in which a solder ball is mounted to a connecting terminal and the solder ball is melted with heat using a solder reflow apparatus. However, in this method, when the connecting terminal is extremely small, the cost involved in producing the solder ball is increased and it is technically difficult to produce a small sized solder ball in some cases.

RELATED DOCUMENT

PATENT DOCUMENT

Patent Document 1: Japanese Unexamined Patent Application Publication No. S 61-276873
Patent Document 2: Japanese Unexamined Patent Application Publication No. 2004-260131

DISCLOSURE OF THE INVENTION

Under the above-described circumstances, it is desired to provide a conductive connecting material that ensures excellent electrical connection between opposed terminals and high insulation reliability between adjacent terminals. In addition, it is desired to provide a conductive connecting material that facilitates connection of electronic members having a plurality of terminals and formation of connecting terminals on an electrode of an electric member.
According to the present invention, there is provided a conductive connecting material used to form conductive portions on a plurality of terminals of an electronic member having a substrate and the plurality of terminals provided on the substrate, including a metal layer and a resin layer having a resin component and a filler, in which the metal layer is aggregated on each of terminals to form the conductive portions on the plurality of terminals by bringing the conductive connecting material into contact with the plurality of terminals and heating the conductive connecting material.
In order to solve the above problems, the present inventors have conducted an extensive study and as a result,

have found that the metal layer is easily aggregated on terminals by the use of a conductive connecting material having a metal layer and a resin layer instead of a film in which conductive particles are dispersed. Therefore, according to the present invention, excellent electrical connection between opposed terminals can be achieved. Meanwhile, it is possible to prevent from remaining of the metal layer in the resin layer, and it is possible to achieve high insulation reliability between adjacent terminals. Furthermore, the metal layer is aggregated on each of terminals by heating the conductive connecting material, so that electronic members having a plurality of terminals can be easily connected to each other and connecting terminals can be easily formed on a plurality of electrodes of electronic members.

According to the present invention, there is provided a method for producing an electronic component including a step of placing the aforementioned conductive connecting material between the two electronic members opposed to each other with the plurality of terminals facing towards the inside and bringing the conductive connecting material into contact with the plurality of terminals of each of the two electronic members, a step of heating the conductive connecting material and connecting the plurality of terminals of each of the two electronic members to each other through the conductive portions formed on the plurality of terminals, and a step of curing or solidifying the resin layer.

According to the present invention, there is provided a method for producing an electronic component including a step of bringing the aforementioned conductive connecting material into contact with the plurality of terminals, a step of heating the aforementioned conductive connecting material to form the conductive portions on the plurality of terminals, and a step of curing or solidifying the resin layer, when the aforementioned terminals are electrodes and the aforementioned conductive portions are connecting terminals.

According to the present invention, there is provided an electronic member with a conductive connecting material, in which the aforementioned conductive connecting material is attached to the substrate of the electronic member so as to contact with the plurality of terminals.

According to the present invention, there is provided an electronic component, in which the plurality of terminals of each of the two electronic members opposed to each other with the plurality of terminals facing towards the inside are connected to each other through the conductive portions formed using the aforementioned conductive connecting material.

EFFECT OF THE INVENTION

According to the present invention, it is possible to provide a conductive connecting material that ensures excellent electrical connection between opposed terminals and high insulation reliability between adjacent terminals, and facilitates connection between electronic members having a plurality of terminals and formation of connecting terminals on an electrode of an electronic member.

BRIEF DESCRIPTION OF THE DRAWINGS

The above and other objects, advantages and features of the present invention will be more apparent from the following description of certain preferred embodiments taken in conjunction with the accompanying drawings, in which:
Fig. 1 is a schematic plan view illustrating one example of the shape of a metal layer used in the present invention.

Fig. 2 is a cross-sectional view schematically illustrating one example of the state of substrates and a conductive connecting material after the conductive connecting material is placed between terminals in the method for connecting an electronic component of the present invention.

Fig. 3 is a cross-sectional view schematically illustrating one example of the state of substrates, conductive areas and insulating areas after the conductive connecting material placed between terminals is heated and cured/solidified in the method for connecting an electronic component of the present invention.

Fig. 4 is a cross-sectional view schematically illustrating one example of the state of substrates and a conductive connecting material after the conductive connecting material is placed between terminals in the method for connecting an electronic component of the present invention.

Fig. 5 is a cross-sectional view schematically illustrating one example of the state of a substrate and a conductive connecting material after the conductive connecting material is placed on electrodes provided on the substrate in the method for producing an electronic component of the present invention.

Fig. 6 is a cross-sectional view schematically illustrating one example of the state of a substrate and a conductive connecting material after the conductive connecting material is placed on electrodes provided on the substrate in the method for producing an electronic component of the present invention.

Fig. 7 is a cross-sectional view schematically illustrating one example of the state of a substrate, conductive areas and insulating areas after the conductive connecting material placed on electrodes of the substrate is heated and cured/solidified in the method for producing an electronic component of the present invention.

DESCRIPTION OF EMBODIMENTS

Hereinafter, the conductive connecting material, the method for connecting an electronic component using the conductive connecting material and the electronic component which is electrically connected using the conductive connecting material according to the present invention will be respectively illustrated in detail.

1. Conductive Connecting Material

The conductive connecting material of the present invention is composed of a resin layer and a metal layer. Its form is a laminate having a multilayer structure consisting of a resin layer and a metal layer. Each of the resin layer and the metal layer may consist of one layer or a plurality of layers. The laminate structure of the conductive connecting material is not particularly limited, and may be a two-layer structure consisting of a resin layer and a metal layer (resin layer/metal layer) or a three-layer structure or multilayer structure having more than three layers, in which one or both of the resin layer and the metal layer consist of a plurality of layers. With the use of a plurality of resin layers or metal layers, compositions of respective layers may be the same or different.

In one embodiment of the present invention, from the viewpoint of reduction of an oxide layer on a metal layer surface using a compound having a flux function, upper and lower layers of the metal layer are preferably resin layers. For example, a three-layer structure (resin layer/metal layer/resin layer) is preferred. In this case, the thicknesses of the resin layers on both sides of the metal layer may be the same or different. The thickness of the resin layer may be suitably adjusted depending on the conductor thickness of a terminal to be connected. For example, in the production of a connecting terminal using a conductive connecting material in which the thicknesses of the resin layers on both sides of the metal layer are different, it is preferable that a thinner resin layer is placed on the connecting terminal side (electrode side). By shortening the distance between the metal layer and the connecting terminal, it becomes easy to control aggregation of the metal layer to the connecting terminal portion.

In another embodiment of the present invention, for example, when producing a connecting terminal on an electronic member such as a semiconductor wafer or the like, a conductive connecting material preferably has a resin layer only on one side of the metal layer since a portion of the metal layer can be exposed. When opposed connecting terminals are connected using a conductive connecting material having a two-layer structure, the conductive connecting material may be placed such that the resin layer side is in contact with a connecting terminal or may be placed such that the metal layer side is in contact with a connecting terminal. When connecting terminals of opposed electronic members are connected using a conductive connecting material having a two-layer structure, it is preferable that the conductive connecting material is attached to both of opposed electronic members and subsequently the electronic members with the conductive connecting material are attached to each other. The orientation of the conductive connecting material may be suitably selected depending on the pattern shape of the metal layer.

Hereinafter, each of the resin layer and the metal layer to be used in the present invention will be described.

(1) Resin Layer

In the present invention, the resin layer is composed of a resin composition containing a resin component and a filler. The resin composition may be in a liquid form or a solid form at room temperature. Herein, the term "a liquid form at room temperature" means a state of not having a certain form at room temperature (25 degrees centigrade) and a paste form is also included therein.

In the present invention, the resin composition may be any of a curable resin composition or a thermoplastic resin composition. Examples of the curable resin composition to be used in the present invention include a curable resin composition that is cured by heating, a curable resin composition that is cured by irradiation with chemical rays and the like. From the viewpoint of excellent mechanical properties such as a coefficient of thermal expansion and an elastic modulus after curing, preferably used is a thermosetting resin composition. The thermoplastic resin composition to be used in the present invention is not particularly limited as long as it has flexibility sufficient to be molded by heating to a predetermined temperature.

(a) Curable Resin Composition

The curable resin composition to be used in the present invention contains a film forming resin, a curing agent, a curing accelerator, a compound having a flux function, a silane coupling agent or the like, in addition to the curable resin and the filler, as necessary.

(i) Curable Resin

The curable resin to be used in the present invention is not particularly limited as long as it can be usually used as an adhesive component for production of a semiconductor device. Examples thereof include an epoxy resin, a phenoxy resin, a silicone resin, an oxetane resin, a phenol resin, a (meth) acrylate resin, a polyester resin (unsaturated polyester resin), a diallyl phthalate resin, a maleimide resin, a polyimide resin (polyimide precursor resin), a bismaleimide-triazine resin and the like. Particularly preferably used is a thermosetting resin containing at least one kind selected from the group consisting of an epoxy resin, a (meth) acrylate resin, a phenoxy resin, a polyester resin, a polyimide resin, a silicone resin, a maleimide resin and a bismaleimide-triazine resin. Among these, preferably used is an epoxy resin from the viewpoints of excellent curability and storage stability, and excellent heat resistance, moisture resistance and chemical resistance of a cured product. These curable resins may be used singly or may be used in combination of two or more kinds.

The content of the curable resin may be suitably set depending on the form of the curable resin composition. For example, when the curable resin composition is in a liquid form, the content of the curable resin is preferably equal to or more than 10% by weight, more preferably equal to or more than 15% by weight, further preferably equal to or more than 20% by weight, further more preferably equal to or more than 25% by weight, much more preferably equal to or more than 30% by weight and particularly preferably equal to or more than 35% by weight, based on the total weight of the curable resin composition. Meanwhile, it is preferably less than 100% by weight, more preferably equal to or less than 95% by weight, further preferably equal to or less than 90% by weight, further more preferably equal to or less than 75% by weight, much more preferably equal to or less than 65% by weight and particularly preferably equal to or less than 55% by weight.

When the curable resin composition is in a solid form, the content of the curable resin is preferably equal to or more than 5% by weight, more preferably equal to or more than 10% by weight, further preferably equal to or more than 15% by weight and particularly preferably equal to or more than 20% by weight, based on the total weight of the curable resin composition. Meanwhile, it is preferably equal to or less than 90% by weight, more preferably equal to or less than 85% by weight, further preferably equal to or less than 80% by weight, further more preferably equal to or less than 75% by weight, much more preferably equal to or less than 65% by weight and particularly preferably equal to or less than 55% by weight.

When the content of the curable resin is within the above range, electrical connection strength and mechanical adhesion strength between terminals can be sufficiently ensured.

In the present invention, any of epoxy resins in a liquid form or a solid form at room temperature may be used. An epoxy resin in a liquid form at room temperature and an epoxy resin in a solid form at room temperature may be used together. When the curable resin composition is in a liquid form, an epoxy resin in a liquid form at room temperature is preferably used. When the curable resin composition is in a solid form, any of epoxy resins in a liquid form or a solid form at room temperature may be used, but when an epoxy resin in a solid form is used, it is preferable that a film forming resin is properly used together.

Preferable examples of the epoxy resin in a liquid form at room temperature (25 degrees centigrade) include a bisphenol A type epoxy resin, a bisphenol F type epoxy resin and the like. The bisphenol A type epoxy resin and the bisphenol F type epoxy resin may be used together.

The epoxy equivalent of the epoxy resin in a liquid form at room temperature is preferably from 150 to 300 g/eq, more preferably from 160 to 250 g/eq, and particularly preferably from 170 to 220 g/eq. When the above epoxy equivalent is less than the above lower limit, the shrinkage ratio of the cured product tends to be increased and warpage is caused in some cases. On the other hand, when it exceeds the above upper limit and a film forming resin is used together, the reactivity with a film forming resin, particularly a polyimide resin, tends to be lowered.

Examples of the epoxy resin in a solid form at room temperature (25 degrees centigrade) include a bisphenol A type epoxy resin, a bisphenol S type epoxy resin, a phenol novolac type epoxy resin, a cresol novolac type epoxy resin, a glycidyl amine type epoxy resin, a glycidyl ester type epoxy resin, a trifunctional epoxy resin, a tetrafunctional epoxy resin and the like. Among these, preferably used are a solid trifunctional epoxy resin, a cresol novolac type epoxy resin and the like. These epoxy resins may be used singly or may be used in combination of two or more kinds.

The epoxy equivalent of the epoxy resin in a solid form at room temperature is preferably from 150 to 3,000 g/eq, more preferably from 160 to 2,500 g/eq, and particularly preferably from 170 to 2,000 g/eq.

The softening point of the epoxy resin in a solid form at room temperature is preferably from 40 to 120 degrees centigrade, more preferably from 50 to 110 degrees centigrade and particularly preferably from 60 to 100 degrees centigrade. When the above softening point is within the above range, tack properties can be suppressed and handling can be facilitated.

(ii) Filler

The filler to be used in the present invention is not particularly limited as long as the performance is stable without causing deterioration during storage at room temperature or upon heating, and an inorganic filler or an organic

filler may be used. The fillers may be used singly or may be used in combination of two or more kinds.

Examples of the inorganic filler include silica, alumina, zinc oxide, magnesium oxide, titanium oxide, antimony oxide, aluminum hydroxide, magnesium hydroxide, boron nitride, calcium carbonate, clay, talc, mica, glass fiber, glass flake, glass bead, barium sulphate and the like. Preferably used are silica and alumina containing impurities as small as possible. These may be used singly or may be used in combination of two or more kinds.

Examples of the organic filler include cellulose, a fluorinated resin, an epoxy resin, a urethane resin, a melamine resin, a phenol resin, an acrylic resin, a polyester resin, a styrene resin, a styrene butadiene copolymer and the like. Preferably used are an epoxy resin and a phenol resin in which the effect of lowering the linear expansion coefficient of the cured product of the resin composition is great. These may be used singly or may be used in combination of two or more kinds.

The shape of the aforementioned filler is preferably spherical or squamous. In particular, a spherical filler is more preferable since it has low anisotropy and therefore it is excellent in an ability to reduce the linear expansion coefficient of the total resin composition. The particle diameter of the filler is preferably equal to or more than 10 nm, more preferably equal to or more than 50 nm and particularly preferably equal to or more than 100 nm. Meanwhile, it is preferably equal to or less than 50 μm, more preferably equal to or less than 20 μm and particularly preferably equal to or less than 10 μm. When the particle diameter of the filler is less than the above lower limit, the workability and dispersibility in the resin composition are lowered. On the other hand, when it exceeds the above upper limit, connection between the terminals by a metal foil is inhibited because of the presence of the filler spread between adjacent terminals.

The content of the filler is preferably equal to or more than 1% by weight, more preferably equal to or more than 10% by weight and particularly preferably equal to or more than 20% by weight, based on the total weight of the curable resin composition. Meanwhile, it is preferably equal to or less than 80% by weight, more preferably equal to or less than 70% by weight and particularly preferably equal to or less than 60% by weight. When the content of the filler is less than the above lower limit, the effect of lowering the linear expansion coefficient of the resin composition after curing is not achieved. On the other hand, when it exceeds the above upper limit, adhesion strength of the resin composition to an adherend is lowered and therefore the reliability of the electronic component is lowered, and the flowability of the resin composition is severely lowered and therefore molding cannot be performed.

Meanwhile, as the content of the aforementioned filler, when the volume of the aforementioned filler is Fv and the volume of the metal layer is Mv, Fv/Mv is preferably from 0.01 to 10.0, further preferably from 0.02 to 8.0 and particularly preferably from 0.05 to 5.0. When Fv/Mv is equal to or more than the above lower limit, the linear expansion coefficient of the resin composition after curing may be effectively reduced, so that the reliability of the electronic component can be improved. Meanwhile, when Fv/Mv is equal to or less than the above upper limit, the metal layer may surely move in the resin composition in the heating step to be described later, so that excellent connection between terminals can be achieved.

In a conductive connecting material having a laminate structure consisting of a resin layer and a metal layer, by mixing a filler into the resin layer, the linear expansion coefficient of the resin layer after curing may be reduced and the stress applied to a connection portion caused by thermal expansion due to heating upon mounting of components or a heat cycle test may be reduced, so that the reliability of the electronic component can be improved. Furthermore, when the filler is mixed, the content ratio of the resin component in the resin layer is reduced, so that the amount of moisture absorption or water absorption of the resin layer after curing can be reduced and heat resistance under moisture absorption of the electronic component can also be improved. Meanwhile, mixing of a filler prevents the metal layer aggregated on each of terminals from flowing out of areas on the terminals. Although the reason is not necessarily clear, it is considered because the filler mixed into the resin layer functions to keep the metal layer aggregated on each of terminals and therefore the filler prevents the metal layer from flowing out of areas on the terminals. Therefore, the reliability of the electronic component can be improved.

(iii) Film Forming Resin

When a curable resin composition in a solid form is used, it is preferable to use the aforementioned curable resin and the film forming resin together. The film forming resin to be used in the present invention is not particularly limited as long as it can be solved in an organic solvent and independently has film forming ability. As the film forming resin, a thermoplastic resin or a thermosetting resin can be used solely, or they can be used in combination. Specific examples of the film forming resin include a (meth)acrylic resin, a phenoxy resin, a polyester resin (saturated polyester resin), a polyurethane resin, a polyimide resin, a polyamide-imide resin, a siloxane-modified polyimide resin, a polybutadiene resin, a polypropylene resin, a styrene-butadiene-styrene copolymer, a styrene-ethylene-butylene-styrene copolymer, a polyacetal resin, a polyvinyl butyral resin, a polyvinyl acetal resin, a butyl rubber, a chloroprene rubber, a polyamide resin, an acrylonitrile-butadiene copolymer, an acrylonitrile-butadiene-acrylic acid copolymer, an acrylonitrile-butadiene-styrene copolymer, polyvinyl acetate, nylon and the like. Among these, preferably used are a (meth)acrylic resin, a phenoxy resin, a polyester resin and a polyimide resin. The film forming resins may be used singly or may be

used in combination of two or more kinds.

As used herein, the term "(meth)acrylic resin" refers to polymers of (meth)acrylic acid and derivatives thereof, or a copolymer of (meth)acrylic acid and a derivative thereof and another monomer. In this regard, when describing "(meth)acrylic acid" or the like, it means an acrylic acid or a methacrylic acid.

Examples of the (meth)acrylic resin to be used in the present invention include polyacrylic acid; polymethacrylic acid; polyacrylic acid esters such as polymethyl acrylate, polyethyl acrylate, polybutyl acrylate, poly (2-ethylhexyl acrylate) and the like; polymethacrylic acid esters such as polymethyl methacrylate, polyethyl methacrylate, polybutyl methacrylate and the like; polyacrylonitrile; polymethacrylonitrile; polyacrylamide; butyl acrylate-ethyl acrylate-acrylonitrile copolymers; acrylonitrile-butadiene copolymers; acrylonitrile-butadiene-acrylic acid copolymers; acrylonitrile-butadiene-styrene copolymers; acrylonitrile-styrene copolymers; methyl methacrylate-styrene copolymers; methyl methacrylate-acrylonitrile copolymers; methyl methacrylate-$\alpha$-methylstyrene copolymers; butyl acrylate-ethyl acrylate-acrylonitrile-2-hydroxyethyl methacrylate-methacrylic acid copolymers; butyl acrylate-ethyl acrylate-acrylonitrile-2-hydroxyethyl methacrylate-acrylic acid copolymers; butyl acrylate-acrylonitrile-2-hydroxyethyl methacrylate copolymers; butyl acrylate-acrylonitrile-acrylic acid copolymers; and ethyl acrylate-acrylonitrile-N,N-dimethylacrylamide copolymers. Among these, preferably used are butyl acrylate-ethyl acrylate-acrylonitrile copolymers and ethyl acrylate-acrylonitrile-N,N-dimethylacrylamide copolymers. These (meth)acrylic resins may be used singly or may be used in combination of two or more kinds.

The skeleton of the phenoxy resin to be used in the present invention is not particularly limited, but preferably used are bisphenol A type, bisphenol F type, biphenyl type and the like.

The polyimide resin to be used in the present invention is not particularly limited as long as it has imide bond in a repeating unit. Examples thereof include those obtained by reacting diamine with acid dianhydride and heating the obtained polyamide acid to cause dehydration and ring closure.

Examples of the aforementioned diamine include aromatic diamines such as 3,3'-dimethyl-4,4'-diaminodiphenyl, 4,6-dimethyl-m-phenylenediamine, 2,5-dimethyl-p-phenylenediamine and the like; and siloxanediamines such as 1,3-bis(3-aminopropyl)-1,1,3,3-tetramethyldisiloxane and the like. These diamines may be used singly or may be used in combination of two or more kinds.

Examples of the aforementioned acid dianhydride include 3,3',4,4'-biphenyl tetracarboxylic acid, pyromellitic dianhydride, 4,4'-oxydiphthalic dianhydride and the like. These acid dianhydrides may be used singly or may be used in combination of two or more kinds.

The polyimide resin may be soluble or insoluble in a solvent, but preferably used is a polyimide resin which is soluble in a solvent because a varnish can be easily obtained at the time of mixing with other components and it is excellent in handling properties. Particularly preferably used is a siloxane-modified polyimide resin because it can be solved in various organic solvents.

The weight average molecular weight of the film forming resin to be used in the present invention is preferably from 8,000 to 1,000,000, more preferably from 8,500 to 950,000 and further preferably from 9,000 to 900,000. When the weight average molecular weight of the film forming resin is within the above-described range, film forming ability can be improved and the flowability of the conductive connecting material before curing can be inhibited. Incidentally, the weight average molecular weight of the film forming resin may be measured by GPC (gel permeation chromatography).

In the present invention, as the film forming resin, a commercial product can be used. Furthermore, various additives such as a plasticizing agent, a stabilizing agent, an antistatic agent, an antioxidant and a pigment may be blended with the film forming resin in the ranges in which the effects of the present invention are not impaired.

In the conductive connecting material to be used in the present invention, the content of the aforementioned film forming resin may be properly set depending on the form of the curable resin composition in use.

For example, in the case of the curable resin composition in a solid form, the content of the film forming resin is preferably equal to or more than 5% by weight, more preferably equal to or more than 10% by weight and particularly preferably equal to or more than 15% by weight, based on the total weight of the curable resin composition. Meanwhile, it is preferably equal to or less than 50% by weight, more preferably equal to or less than 45% by weight and particularly preferably equal to or less than 40% by weight. When the content of the film forming resin is within the aforementioned range, the flowability of the curable resin composition before melted may be suppressed and therefore handling properties of the conductive connecting material can be facilitated.

(iv) Curing Agent

As the curing agent to be used in the present invention, preferably used are phenols, acid anhydrides and amine compounds. The curing agent may be suitably selected depending on the kind of the curable resin and the like. For example, when an epoxy resin is used as a curable resin, phenols are preferably used as the curing agent from the viewpoints of excellent reactivity with the epoxy resin, small change in size at the time of curing and suitable physical properties (for example, heat resistance and moisture resistance) after curing, while bifunctional or higher functional phenols are more preferably used from the viewpoint of excellent physical properties after curing of the curable resin.

Furthermore, these curing agents may be used singly or may be used in combination of two or more kinds.

Examples of the aforementioned phenols include bisphenol A, tetramethyl bisphenol A, diallyl bisphenol A, biphenol, bisphenol F, diallyl bisphenol F, trisphenol, tetrakisphenol, a phenol novolac resin, a cresol novolac resin and the like. Among these, preferably used are a phenol novolac resin and a cresol novolac resin from the viewpoints of excellent reactivity with the epoxy resin and excellent physical properties after curing.

The content of the curing agent may be suitably selected depending on the kind of the curable resin or the curing agent in use, and when a compound having a flux function to be described later has a functional group functioning as the curing agent, the kind of the functional group and use amount.

For example, when an epoxy resin is used as the curable resin, the content of the curing agent is preferably from 0.1 to 50% by weight, more preferably from 0.2 to 40% by weight and particularly preferably from 0.5 to 30% by weight, based on the total weight of the curable resin composition. When the content of the curing agent is within the aforementioned range, electrical connection strength and mechanical adhesion strength between terminals can be sufficiently ensured.

(v) Curing Accelerator

Examples of the curing accelerator to be used in the present invention include imidazole compounds such as imidazole, 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecyl imidazolium trimellitate, 1-cyanoethyl-2-phenyl imidazolium trimellitate, 2,4-diamino-6-[2'-methyl imidazolyl(1')]-ethyl-s-triazine, 2,4-diamino-6-[2'-undecyl imidazolyl(1')]-ethyl-s-triazine, 2,4-diamino-6-[2'-ethyl-4-methyl imidazolyl(1')]-ethyl-s-triazine, 2,4-diamino-6-[2'-methyl imidazolyl(1')]-ethyl-s-triazine-isocyanuric acid addition product, 2-phenylimidazole-isocyanuric acid addition product, 2-methylimidazole-isocyanuric acid addition product, 2-phenyl-4,5-dihydroxydimethyl imidazole, 2-phenyl-4-methyl-5-hydroxymethyl imidazole and the like.

The content of the curing accelerator may be suitably set depending on the kind of the curing accelerator in use. For example, when an imidazole compound is used, the content of the imidazole compound is preferably equal to or more than 0.001% by weight, more preferably equal to or more than 0.003% by weight and particularly preferably equal to or more than 0. 005% by weight, based on the total weight of the curable resin composition. Meanwhile, it is preferably equal to or less than 1.0% by weight, more preferably equal to or less than 0.7% by weight and particularly preferably equal to or less than 0.5% by weight. When the content of the imidazole compound is less than the aforementioned lower limit, the function as the curing accelerator may not fully exerted, and thereby the curable resin composition may not be fully cured in some cases. On the other hand, when the content of the imidazole compound exceeds the aforementioned upper limit, the metal layer does not fully move on the terminal surface before curing of the curable resin composition is completed and the metal layer is remained in the insulating area, so that the insulation properties cannot be sufficiently ensured in some cases. Furthermore, storage stability of the conductive connecting material is lowered in some cases.

(vi) Compound Having Flux Function

The compound having a flux function to be used in the present invention has an action of reducing a metal oxide layer such as oxide layers on surfaces of terminal and metal foil. For example, as the compound having a flux function, preferably used is a compound having a phenolic hydroxyl group and/or a carboxyl group. Examples of the compound having a phenolic hydroxyl group include monomers containing a phenolic hydroxyl group such as phenol, o-cresol, 2,6-xylenol, p-cresol, m-cresol, o-ethylphenol, 2,4-xylenol, 2,5-xylenol, m-ethylphenol, 2,3-xylenol, mesitol, 3,5-xylenol, p-tert-butylphenol, catechol, p-tert-amylphenol, resorcinol, p-octylphenol, p-phenylphenol, bisphenol F, bisphenol AF, biphenol, diallyl bisphenol F, diallyl bisphenol A, trisphenol, tetrakisphenol and the like; and resins containing a phenolic hydroxyl group such as a phenol novolac resin, an o-cresol novolac resin, a bisphenol F novolac resin, a bisphenol A novolac resin and the like.

Examples of the compound having a carboxyl group include aliphatic acid anhydride, alicyclic acid anhydride, aromatic acid anhydride, aliphatic carboxylic acid, aromatic carboxylic acid and the like. Examples of the aforementioned aliphatic acid anhydride include succinic anhydride, polyadipic acid anhydride, polyazelaic acid anhydride, polysebacic acid anhydride and the like. Examples of the aforementioned alicyclic acid anhydride include methyltetrahydrophthalic anhydride, methylhexahydrophthalic anhydride, methyl himic anhydride, hexahydrophthalic anhydride, tetrahydrophthalic anhydride, trialkyltetrahydrophthalic anhydride, methylcyclohexenedicarboxylic anhydride and the like. Examples of the aforementioned aromatic acid anhydride include phthalic anhydride, trimellitic anhydride, pyromellitic anhydride, benzophenone tetracarboxylic anhydride, ethylene glycol bistrimellitate, glycerol tristrimellitate and the like.

Examples of the aforementioned aliphatic carboxylic acid include formic acid, acetic acid, propionic acid, butyric acid, valeric acid, pivalic acid, caproic acid, caprylic acid, lauric acid, myristic acid, palmitic acid, stearic acid, acrylic

acid, methacrylic acid, crotonic acid, oleic acid, fumaric acid, maleic acid, oxalic acid, malonic acid, succinic acid, glutaric acid, adipic acid, sebacic acid, dodecanedioic acid, pimelic acid and the like. Among these, preferably used is an aliphatic carboxylic acid represented by the following formula (1), and more preferably used are adipic acid, sebacic acid and dodecanedioic acid,

$$HOOC-(CH_2)_n-COOH \qquad (1)$$

wherein, in the formula (1), n is an integer of from 1 to 20.

The structure of the aromatic carboxylic acid is not particularly limited, but preferably used is a compound represented by the following formula (2) or (3),

[Chemical Formula 1]

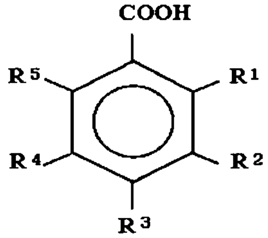

(2)

wherein, in the formula, $R^1$ to $R^5$ are each independently a monovalent organic group; and at least one of $R^1$ to $R^5$ is a hydroxyl group,

[Chemical Formula 2]

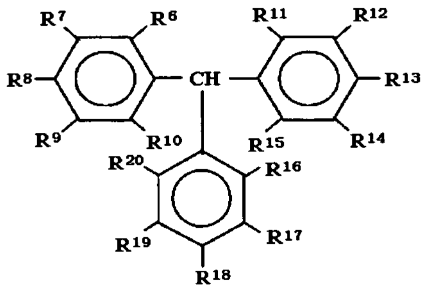

(3)

wherein, in the formula, $R^6$ to $R^{20}$ are each independently a monovalent organic group; and at least one of $R^6$ to $R^{20}$ is a hydroxyl group or a carboxyl group.

Examples of the aromatic carboxylic acid include benzoic acid derivatives such as benzoic acid, phthalic acid, isophthalic acid, terephthalic acid, hemimellitic acid, trimellitic acid, trimesic acid, mellophanic acid, prehnitic acid, pyromellitic acid, mellitic acid, xylic acid, hemellitic acid, mesitylene acid, prehnitylic acid, toluic acid, cinnamic acid, salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid, gallic acid (3,4,5-trihydroxybenzoic acid) and the like; naphthoic acid derivatives such as 1,4-dihydroxy-2-naphthoic acid, 3,5-dihydroxy-2-naphthoic acid, 3,5-2-dihydroxy-2-naphthoic acid and the like; phenolphthalin; diphenolic acid and the like.

Among these, in the present invention, preferably used is a compound which has a flux function and acts as a curing agent for the curable resin. That is, as the compound having a flux function to be used in the present invention, preferably used is a compound which exerts the effect of reducing an oxide layer on the surface of metal such as the metal layer and terminal, and has a functional group capable of reacting with a curable resin. The functional group is suitably selected depending on the kind of the curable resin. For example, when an epoxy resin is used as the curable resin, the functional group is preferably capable of reacting with an epoxy group such as a carboxyl group, a hydroxyl group and an amino group. The compound having a flux function which also acts as the curing agent reduces the oxide layer on the surface of metal such as the metal layer and terminal to improve wettability on the surface of the metal, and to facilitate formation of the conductive area. Also, after the conductive area is formed, the elastic modulus or Tg of the resin can be increased with the addition of the compound to the curable resin. Meanwhile, by the action of the compound having a flux function as the curing agent, a flux washing can be unnecessary, and generation of ion migration caused by flux residue can be suppressed.

Such a compound having a flux function preferably has at least one carboxyl group. For example, when an epoxy resin is used as the curable resin, examples of the compound include aliphatic dicarboxylic acid and compounds having a carboxyl group and a phenolic hydroxyl group.
The aliphatic dicarboxylic acid is preferably a compound in which two carboxyl groups are bonded to an aliphatic hydrocarbon group. The aliphatic hydrocarbon group may be saturated or unsaturated acyclic, or may be saturated or unsaturated cyclic. Meanwhile, when the aliphatic hydrocarbon group is acyclic, it may be linear or branched.
Such an aliphatic dicarboxylic acid is preferably a compound in which, in the above formula (1), n is an integer of from 1 to 20. When n in the above formula (1) is within the above range, flux activity, outgas at the time of adhesion, and a balance between the elastic modulus and glass transition temperature after curing of the conductive connecting material are excellent. In particular, n is preferably equal to or more than 3 from the fact that an increase in the elastic modulus after curing of the conductive connecting material may be suppressed and adhesion to an adherend may be improved. Furthermore, n is preferably equal to or less than 10 from the fact that a decrease in the elastic modulus may be suppressed and the connection reliability may be further improved.
Examples of the aliphatic dicarboxylic acid represented by the above formula (1) include glutaric acid, adipic acid, pimelic acid, suberic acid, azelaic acid, sebacic acid, undecanedioic acid, dodecanedioic acid, tridecanedioic acid, tetradecanedioic acid, pentadecanedioic acid, octadecanedioic acid, nonadecanedioic acid, eicosanedioic acid and the like. Among these, preferably used are adipic acid, suberic acid, sebacic acid and dodecanedioic acid, while particularly preferably used is sebacic acid.
Examples of the aforementioned compound having a carboxyl group and a phenolic hydroxyl group include benzoic acid derivatives such as salicylic acid, 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid, gallic acid (3,4,5-trihydroxybenzoic acid) and the like; naphthoic acid derivatives such as 1,4-dihydroxy-2-naphthoic acid, 3,5-dihydroxy-2-naphthoic acid and the like; phenolphthalin; diphenolic acid and the like. Among these, preferably used are phenolphthalin, gentisic acid, 2,4-dihydroxybenzoic acid and 2,6-dihydroxybenzoic acid, while particularly preferably used are phenolphthalin and gentisic acid.
The compounds having a flux function may be used singly or may be used in combination of two or more kinds. Furthermore, any of these compounds has high moisture absorption and causes voids, so that the compound having a flux function is preferably dried in advance prior to use.
The content of the compound having a flux function may be suitably set depending on the form of the resin composition in use.
For example, when the resin composition is in a liquid form, the content of the compound having a flux function is preferably equal to or more than 1% by weight, more preferably equal to or more than 2% by weight and particularly preferably equal to or more than 3% by weight, based on the total weight of the curable resin composition. Meanwhile, it is preferably equal to or less than 50% by weight, more preferably equal to or less than 40% by weight, further preferably equal to or less than 30% by weight and particularly preferably equal to or less than 25% by weight.
When the resin composition is in a solid form, the content of the compound having a flux function is preferably equal to or more than 1% by weight, more preferably equal to or more than 2% by weight and particularly preferably equal to or more than 3% by weight, based on the total weight of the curable resin composition. Meanwhile, it is preferably equal to or less than 50% by weight, more preferably equal to or less than 40% by weight, further preferably equal to or less than 30% by weight and particularly preferably equal to or less than 25% by weight.
When the content of the compound having a flux function is within the above range, oxide layers on surfaces of metal layer and terminal can be removed to the extent that it can be electrically connected. Furthermore, when a resin composition is the curable resin, at the time of curing, the compound can be efficiently added to the resin to increase the elastic modulus or Tg of the resin. Moreover, generation of ion migration caused by the unreacted compound having a flux function can be suppressed.

(vii) Silane Coupling Agent

Examples of the silane coupling agent to be used in the present invention include an epoxysilane coupling agent, an aromatic ring-containing aminosilane coupling agent and the like. With the addition of the silane coupling agent, adhesion between the bonding member and the conductive connecting material can be improved. The silane coupling agents may be used singly or may be used in combination of two or more kinds.
The content of the silane coupling agent may be suitably selected depending on the kinds of the bonding member and the curable resin. For example, the content of the silane coupling agent is preferably equal to or more than 0.01% by weight, more preferably equal to or more than 0.05% by weight and particularly preferably equal to or more than 0.1% by weight, based on the total weight of the curable resin composition. Meanwhile, it is preferably equal to or less than 2% by weight, more preferably equal to or less than 1.5% by weight and particularly preferably equal to or less than 1% by weight.

A plasticizing agent, a stabilizing agent, an adhesion-imparting agent, a lubricant, a filler, an antistatic agent, an antioxidant, a pigment or the like may be blended with the curable resin composition to be used in the present invention in the ranges in which the effects of the present invention are not impaired.

In the present invention, the aforementioned curable resin composition can be prepared by mixing and dispersing respective components. A method of mixing and dispersing respective components is not particularly limited, and the components can be mixed and dispersed in a conventionally known method.

Furthermore, in the present invention, the aforementioned respective components may be mixed in the presence or absence of a solvent to prepare a curable resin composition in a liquid form. The solvent to be used at this time is not particularly limited as long as it is inactive with respect to respective components. Examples thereof include ketones such as acetone, methyl ethyl ketone (MEK), methyl isobutyl ketone (MIBK), diisobutyl ketone (DIBK), cyclohexanone, diacetone alcohol (DAA) and the like; aromatic hydrocarbons such as benzene, xylene, toluene and the like; alcohols such as methyl alcohol, ethyl alcohol, isopropyl alcohol, n-butyl alcohol and the like; cellosolves such as methyl cellosolve, ethyl cellosolve, butyl cellosolve, methyl cellosolve acetate, ethyl cellosolve acetate and the like; N-methyl-2-pyrrolidone (NMP), tetrahydrofuran (THF), dimethylformamide (DMF), dibasic ester (DBE), ethyl 3-ethoxypropionate (EEP), dimethyl carbonate (DMC) and the like. The amount of the solvent in use is preferably within the range in which the solid concentration in the components mixed in the solvent is from 10 to 60% by weight.

(b) Thermoplastic Resin Composition

In the present invention, a thermoplastic resin composition may also be used as the resin composition.
The thermoplastic resin composition to be used in the present invention contains a compound having a flux function, a silane coupling agent or the like, in addition to the thermoplastic resin and the filler, as necessary.

(i) Thermoplastic Resin

Examples of the thermoplastic resin to be used in the present invention include vinyl acetate, a polyvinyl alcohol resin, a polyvinyl butyral resin, a vinyl chloride resin, a (meth) acrylic resin, a phenoxy resin, a polyester resin, a polyimide resin, a polyamide-imide resin, a siloxane-modified polyimide resin, a polybutadiene resin, an acrylic resin, a styrene resin, a polyethylene resin, a polypropylene resin, a polyamide resin, a cellulose resin, an isobutylene resin, a vinyl ether resin, a liquid crystal polymer resin, a polyphenylene sulfide resin, a polyphenylene ether resin, a polyether sulfone resin, a polyetherimide resin, a polyetherether ketone resin, a polyurethane resin, a styrene-butadiene-styrene copolymer, a styrene-ethylene-butylene-styrene copolymer, a polyacetal resin, a polyvinyl acetal resin, a butyl rubber, a chloroprene rubber, an acrylonitrile-butadiene copolymer, an acrylonitrile-butadiene-acrylic acid copolymer, an acrylonitrile-butadiene-styrene copolymer, polyvinyl acetate and the like. The thermoplastic resin may be a single polymer or may be a copolymer consisting of two or more kinds of the aforementioned thermoplastic resins.

The softening point of the thermoplastic resin is not particularly limited, but it is preferably equal to or more than 10 degrees centigrade lower than the melting point of the metal layer constituting the conductive connecting material, particularly preferably equal to or more than 20 degrees centigrade lower, and more preferably equal to or more than 30 degrees centigrade lower.

Meanwhile, the decomposition temperature of the thermoplastic resin is not particularly limited, but it is preferably equal to or more than 10 degrees centigrade higher than the melting point of the metal layer constituting the conductive connecting material, particularly preferably equal to or more than 20 degrees centigrade higher, and more preferably equal to or more than 30 degrees centigrade higher.

The content of the thermoplastic resin may be suitably set depending on the form of the thermoplastic resin composition in use.
For example, when a thermoplastic resin composition is in a liquid form, the content of the thermoplastic resin is preferably equal to or more than 10% by weight, more preferably equal to or more than 15% by weight, further preferably equal to or more than 20% by weight, further more preferably equal to or more than 25% by weight, much more preferably equal to or more than 30% by weight, and particularly preferably equal to or more than 35% by weight, based on the total weight of the thermoplastic resin composition. Meanwhile, it is preferably equal to or less than 100% by weight, more preferably equal to or less than 95% by weight, further preferably equal to or less than 90% by weight, further more preferably equal to or less than 75% by weight, much more preferably equal to or less than 65% by weight, and particularly preferably equal to or less than 55% by weight.
When a thermoplastic resin composition is in a solid form, the content of the thermoplastic resin is preferably equal to or more than 5% by weight, more preferably equal to or more than 10% by weight, further preferably equal to or more than 15% by weight, and particularly preferably equal to or more than 20% by weight, based on the total weight of the thermoplastic resin composition. Meanwhile, it is preferably equal to or less than 90% by weight, more preferably equal to or less than 85% by weight, further preferably equal to or less than 80% by weight, further more preferably equal to

or less than 75% by weight, much more preferably equal to or less than 65% by weight, and particularly preferably equal to or less than 55% by weight.
When the content of the thermoplastic resin is within the above range, electrical connection strength and mechanical adhesion strength between terminals can be sufficiently ensured.

(ii) Other Additives

A filler, a compound having a flux function, a silane coupling agent and other additives to be used for the thermoplastic resin composition of the present invention may be the same as those described in the aforementioned (a) Curable Resin Composition. The contents of respective components, preferable compounds and production methods are also the same as those described in the Curable Resin Composition.
In the present invention, a curable resin composition is preferably used as the resin composition. It is more preferable to contain an epoxy resin in an amount of 10 to 90% by weight, a filler in an amount of 1 to 80% by weight, a curing agent in an amount of 0.1 to 50% by weight, a film forming resin in an amount of 5 to 50% by weight and a compound having a flux function in an amount of 1 to 50% by weight, based on the total weight of the resin composition. Meanwhile, it is further preferable to contain an epoxy resin in an amount of 20 to 80% by weight, a filler in an amount of 10 to 70% by weight, a curing agent in an amount of 0.2 to 40% by weight, a film forming resin in an amount of 10 to 45% by weight and a compound having a flux function in an amount of 2 to 40% by weight, based on the total weight of the resin composition. Meanwhile, it is particularly preferable to contain an epoxy resin in an amount of 35 to 55% by weight, a filler in an amount of 20 to 60% by weight, a curing agent in an amount of 0.5 to 30% by weight, a film forming resin in an amount of 15 to 40% by weight and a compound having a flux function in an amount of 3 to 25% by weight, based on the total weight of the resin composition.
The thickness of the resin layer in the conductive connecting material of the present invention is not particularly limited, but it is preferably equal to or more than 1 μm, more preferably equal to or more than 3 μm and particularly preferably equal to or more than 5 μm. Meanwhile, the thickness of the resin layer is preferably equal to or less than 200 μm, more preferably equal to or less than 150 μm and particularly preferably equal to or less than 100 μm. When the thickness of the resin layer is within the above range, the gap between adjacent terminals can be sufficiently filled with the resin composition. Therefore, after the resin composition is cured, mechanical adhesion strength after solidification and electrical connection between opposed terminals can be sufficiently ensured, and connecting terminals can also be produced.
When the conductive connecting material of the present invention contains a plurality of resin layers, formulations of respective resin layers may be the same or may be different depending on the kind of the resin component in use and difference in formulations. Physical properties such as the melt viscosity and the softening temperature of respective resin layers may be the same or different. For example, a resin layer in a liquid form and a resin layer in a solid form may be used in combination.
For the resin layer of the present invention, the average linear expansion coefficient at from room temperature to 100 degrees centigrade is preferably from 3 to 70 ppm. In this case, the stress applied to a connection portion for electrically connecting electronic members caused by thermal expansion due to heating upon mounting of components or a heat cycle test may be reduced.

(2) Metal Layer

The metal layer in the present invention is a layer consisting of a metal foil. The metal layer may be formed on at least a portion of the resin layer in a planar view or may be formed on the entire surface of the resin layer.
The shape of the metal layer is not particularly limited. A predetermined shape may be formed in a repeated pattern, or the shape may be irregular. A regular shape and an irregular shape may coexist. Fig. 1 is a schematic plan view illustrating one example of the shape of the metal layer. Metal layers 110 having various shapes are formed on resin layers 120. Examples of the shape of the metal layer include (a) a dotted line-like hole pattern, (b) a stripe pattern, (c) a polka-dot pattern, (d) a rectangle pattern, (e) a checker pattern, (f) a frame pattern, (g) a lattice pattern and (h) a multiple frame pattern as shown in Fig. 1. These shapes are a part of examples and may be combined or modified depending on purposes and applications.
In one embodiment of the present invention, when a full grid type adherend is connected such that an electrode to be connected is placed on the entire connection surface of the adherend, it is preferable to form a sheet-like metal layer on the entire surface of the resin layer.
Meanwhile, when a peripheral type adherend is connected such that an electrode to be connected is placed in the periphery of the connection surface of the adherend, it is preferable to form a metal layer in a repeated pattern on at least a portion of a resin layer from the viewpoints of effective use of the metal layer and the absence of remained metal layer between adjacent electrodes. In this case, the shape of the metal layer may be suitably selected depending

on the pitch, form and the like of the electrode.

The metal layer to be used in the present invention preferably has an oxide layer on a surface of the metal layer that can be removed by the reduction of the compound having a flux function. The metal layer is preferably made of an alloy of at least two or more metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge) and copper (Cu), or tin alone.

Among these, in consideration of the melting temperature and mechanical properties, as the metal layer, more preferably used are solder foils consisting of alloys containing Sn such as Sn-Pb alloy, and Sn-Bi alloy, Sn-Ag-Cu alloy, Sn-In alloy and Sn-Ag alloy that are lead-free solders. When Sn-Pb alloy is used, the content ratio of tin is preferably equal to or more than 30% by weight and less than 100% by weight, more preferably equal to or more than 35% by weight and less than 100% by weight, and particularly preferably equal to or more than 40% by weight. Meanwhile, it is preferably less than 100% by weight. Furthermore, when lead free solders are used, the content ratio of tin is preferably equal to or more than 15% by weight and less than 100% by weight, more preferably equal to or more than 20% by weight and less than 100% by weight, and particularly preferably equal to or more than 25% by weight and less than 100% by weight. Preferable examples of the Sn-Pb alloy include Sn63-Pb (melting point: 183 degrees centigrade), Sn-3.0Ag-0.5Cu (melting point: 217 degrees centigrade), Sn-3.5Ag (melting point: 221 degrees centigrade), Sn-58Bi (melting point: 139 degrees centigrade), Sn-9.0Zn (melting point: 199 degrees centigrade), Sn-3.5Ag-0.5Bi-3.0In (melting point: 193 degrees centigrade), Au-20Sn (melting point: 280 degrees centigrade) and the like.

The metal layer may be suitably selected depending on heat resistance of an electronic member and a semiconductor device to be connected. For example, regarding connection between terminals in a semiconductor device, in order to prevent damage of members of the semiconductor device due to heat history, it is preferable to use a metal layer having a melting point of equal to or less than 330 degrees centigrade (more preferably equal to or less than 300 degrees centigrade, particularly preferably equal to or less than 280 degrees centigrade and further preferably equal to or less than 260 degrees centigrade). In addition, in order to ensure heat resistance of the semiconductor device after connection between terminals, it is preferable to use a metal layer having a melting point of equal to or more than 100 degrees centigrade (more preferably equal to or more than 110 degrees centigrade and particularly preferably equal to or more than 120 degrees centigrade). The melting point of the metal layer may be measured using a differential scanning calorimeter (DSC).

The thickness of the metal layer may be suitably selected depending on the gap between opposed terminals, the distance between adjacent terminals and the like. For example, in the case of connection between respective connecting terminals of a semiconductor chip, a substrate, a semiconductor wafer and the like in a semiconductor device, the thickness of the metal layer is preferably equal to or more than 0.5 $\mu$m, more preferably equal to or more than 3 $\mu$m and particularly preferably equal to or more than 5 $\mu$m. Meanwhile, it is preferably equal to or less than 100 $\mu$m, more preferably equal to or less than 50 $\mu$m and particularly preferably equal to or less than 20 $\mu$m. When the thickness of the metal layer is less than the aforementioned lower limit, the number of unconnected terminals tends to be increased due to lack of metal for constituting the conductive portion. On the other hand, when the thickness exceeds the aforementioned upper limit, shorting circuit tends to easily occur because of occurring of bridging between adjacent terminals due to excess metal.

Examples of the method for preparing a metal layer include a method in which a metal layer is prepared by rolling of mass of ingot or the like and a method in which a metal layer is formed by direct evaporation, sputtering, plating or the like to a resin layer. Further, examples of the method for preparing a metal layer in a repeated pattern include a method in which a metal layer is punched out in a predetermined pattern, a method in which a predetermined pattern is formed by etching or the like, and a method in which a metal layer is formed by evaporation, sputtering, plating or the like using a shielding plate, a mask or the like.

The content of the metal layer is preferably equal to or more than 5% by weight, more preferably equal to or more than 20% by weight and particularly preferably equal to or more than 30% by weight, based on the total weight of the conductive connecting material. Meanwhile, it is preferably less than 100% by weight, more preferably equal to or less than 80% by weight and particularly preferably equal to or less than 70% by weight. When the content of the metal layer is less than the aforementioned lower limit, the number of unconnected terminals is increased due to lack of metal for constituting the conductive portion in some cases. On the other hand, when the content of the metal layer exceeds the aforementioned upper limit, bridging between adjacent terminals tends to easily occur due to excess metal.

Alternatively, the content of the metal layer may be defined by the volume ratio with respect to the conductive connecting material. For example, the content of the metal layer is preferably equal to or more than 1% by volume, more preferably equal to or more than 5% by volume and particularly preferably equal to or more than 10% by volume, based on the conductive connecting material. Meanwhile, it is preferably equal to or less than 90% by volume, more preferably equal to or less than 80% by volume and particularly preferably equal to or less than 70% by volume. When the content of the metal layer is less than the aforementioned lower limit, the number of unconnected terminals is increased due to lack of metal for constituting the conductive portion in some cases. On the other hand, when the content of the metal

layer exceeds the aforementioned upper limit, bridging between adjacent terminals tends to easily occur due to excess metal.

In the present invention, the form of the conductive connecting material may be suitably selected depending on the form of the resin composition and the like. For example, in the case of the resin composition in a liquid form, a product in which the resin composition is coated on both sides of the metal layer, or a product in which the resin composition is coated on the surface of a release substrate such as a polyester sheet, drying and film forming are performed at a predetermined temperature for the purpose of semi-curing (B-stage) or the like, and after that the metal layer is attached thereto to form a film or the like can be provided as the conductive connecting material. In the case of the resin composition in a solid form, a product in which a varnish of the resin composition dissolved in an organic solvent is coated on the surface of a release substrate such as a polyester sheet, drying is performed at a predetermined temperature, and after that the metal layer is attached thereto or subjected to evaporation or the like to form a film can be provided as the conductive connecting material.

In addition, the conductive connecting material of the present invention and the metal layer to be used for the conductive connecting material can be embossed in order to enhance contact to terminals.

The thickness of the conductive connecting material of the present invention is not particularly limited, but it is preferably equal to or more than 1 μm, more preferably equal to or more than 3 μm and particularly preferably equal to or more than 5 μm. Meanwhile, it is preferably equal to or less than 200 μm, more preferably equal to or less than 150 μm and particularly preferably equal to or less than 100 μm. When the thickness of the conductive connecting material is within the aforementioned range, the gap between adjacent terminals can be sufficiently filled with the resin composition. In addition, mechanical adhesion strength after curing or solidifying of the resin component and the electrical connection between terminals opposed to each other can be sufficiently ensured. Moreover, it is also possible to produce connecting terminals depending on purposes and applications.

Hereinafter, the method for producing a conductive connecting material will be described.
When the resin composition to be used in the present invention is in a liquid form at 25 degrees centigrade, for example, the metal layer is immersed in the resin composition in a liquid form to allow the resin composition in a liquid form to adhere to both surfaces of the metal layer, thereby producing the conductive connecting material of the present invention. When it is necessary to control the thickness of the resin composition, a method in which the metal layer immersed in the resin composition in a liquid form is passed through a bar coater having a certain gap, or a method in which the resin composition in a liquid form is sprayed using a spray coater or the like can be employed to produce the conductive connecting material.

When the resin composition to be used in the present invention is in a film form at 25 degrees centigrade, for example, the conductive connecting material can be produced in the manner described below. First, a varnish of the resin composition dissolved in an organic solvent is coated on the surface of a release substrate such as a polyester sheet, and drying and film-forming are performed at a predetermined temperature to prepare a resin composition in a film form. Next, two films of the resin composition formed on the release substrate are prepared, and the metal layer is sandwiched between the two sheets to be subjected to lamination using a hot roll, thereby preparing a conductive connecting material having three layers consisting of a resin layer, a metal layer and a resin layer in which the resin layer is placed on both surfaces of the metal layer. Further, when the resin layer is placed on one surface of the metal layer using the above-described lamination method, a conductive connecting material having two layers consisting of a resin layer and a metal layer can be prepared.

When a rolled metal layer is used, the metal layer is used as a base substrate, and the aforementioned resin composition in a film form is placed on both surfaces or one surface of the metal layer to be subjected to lamination using a hot roll, thereby obtaining a rolled conductive connecting material. In addition, when a rolled metal layer is used, the resin composition in a varnish form is directly coated on both surfaces or one surface of the metal layer and a solvent is volatilized, thereby preparing a rolled conductive connecting material.

When a conductive connecting material is prepared with the use of a metal layer in a pattern, a metal layer is placed on a release substrate, the metal layer is half-cut with a die from the metal layer side, and excess metal layer is removed to prepare a metal layer in a pattern. Then, the aforementioned resin composition in a film form may be laminated thereon using a hot roll. When the resin layer is provided on both surfaces of the metal layer in a pattern, the release substrate is released and the resin composition in a film form may be further laminated on the surface of the metal layer in a pattern opposite to the surface on which the resin layer is already formed.
The method for producing a conductive connecting material is not particularly limited to the above-described methods. The method for producing a conductive connecting material may be suitably selected by those skilled in the art depending on purposes and applications.

2. First Method for Producing Electronic Component

Hereinafter, the first method for producing an electronic component according to the present invention will be

described. The first method for producing an electronic component according to the present invention relates to a method for connecting terminals using the aforementioned conductive connecting material, and involves a placement step of placing the conductive connecting material between two opposed electronic members with a plurality of terminals facing towards the inside and bringing the conductive connecting material into contact with the plurality of terminals of each of the two electronic members, a heating step of heating the aforementioned conductive connecting material and connecting the plurality of terminals of each of the two electronic members to each other through the conductive portions formed on the plurality of terminals, and a curing/solidifying step of curing or solidifying the aforementioned resin layer. The first method for producing an electronic component according to the present invention can be used, for example, at the time of connecting terminals formed in semiconductor wafers, semiconductor chips, rigid substrates, flexible substrates and other electronic components.

In the first method for producing an electronic component according to the present invention, steps involved in the connecting method when the resin composition of the conductive connecting material is a curable resin composition are slightly different from steps involved in the connecting method when the resin composition is a thermoplastic resin composition. Hereinafter, the case where the resin layer of the conductive connecting material has a curable resin is designated as the first embodiment, the case where the resin layer has a thermoplastic resin is designated as the second embodiment, and these embodiments will be described independently.

(1) First Embodiment

In the first method for producing an electronic component according to the first embodiment of the present invention, the step of connecting electronic members to each other is carried out by heating the conductive connecting material at a temperature of equal to or more than the melting point of the metal layer and a temperature at which curing of the resin layer is not completed, while the step of curing or solidifying the resin layer is carried out by heating the conductive connecting material at a temperature at which curing of the resin layer is completed.

According to this production method, it is possible to selectively aggregate the heated and melted metal layer between terminals to form a conductive area and to form an insulating area by the curable resin composition around the conductive area. As a result, a leak current can be prevented by ensuring the insulation properties between adjacent terminals, and therefore the connection reliability of connection between terminals can be improved. In addition, it is possible to electrically connect a plurality of terminals in a fine pitch circuit at one time and to facilitate connection between electronic members having a plurality of terminals. Moreover, by curing the curable resin composition, the mechanical strength of the conductive area or the insulating area can be improved.

Hereinafter, a preferred embodiment of the first method for producing an electronic component according to the first embodiment of the present invention will be described in detail with reference to the drawings, but the connecting method of the present invention is not limited to the drawings.

(a) Placement Step

First, as shown in Fig. 2, a substrate 10 on which a plurality of terminals 11 are provided and a substrate 20 on which a plurality of terminals 21 are provided are positioned such that the plurality of terminals 11 are opposed to the plurality of terminals 21. A conductive connecting material 30 having a metal layer 110 and resin layers 120 composed of a curable resin composition provided on both surfaces of the metal layer 110 is placed between these terminals. In this case, as shown in Fig. 4, the conductive connecting material 30 may be bonded to one or both of the substrate 10 and the substrate 20 by thermal compression in advance using a roll laminator, a pressing apparatus or the like. Furthermore, the surfaces of the terminals 11 and 21 may be subjected to treatments such as washing, polishing, plating and surface activation in order to provide good electrical connection, as necessary. Then, the conductive connecting material 30 is come into contact with the plurality of terminals 11 and the plurality of terminals 21.

(b) Heating Step

In the heating step, the conductive connecting material 30 placed between the terminals in the aforementioned placement step is heated at a temperature of equal to or more than the melting point of the metal layer 110. The heating temperature may be equal to or more than the melting point of the metal layer 110. For example, the upper limit is not particularly limited as long as the temperature is within a range in which the metal layer 110 can move in the curable resin, that is, curing of the resin layer 120 composed of the curable resin composition is not completed by adjusting the heating time (for example, reducing the heating time). The heating temperature is preferably equal to or more than 5 degrees centigrade higher than the melting point of the metal layer 110, more preferably equal to or more than 10 degrees centigrade higher, further preferably equal to or more than 20 degrees centigrade higher, and particularly preferably equal to or more than 30 degrees centigrade higher.

The heating temperature may be suitably selected depending on compositions of the metal layer and the curable resin composition in use, but it is preferably equal to or more than 100 degrees centigrade, more preferably equal to or more than 130 degrees centigrade, particularly preferably equal to or more than 140 degrees centigrade, and most preferably equal to or more than 150 degrees centigrade. In order to prevent heat deterioration of substrates to be connected or the like, the heating temperature is preferably equal to or less than 260 degrees centigrade, more preferably equal to or less than 250 degrees centigrade and particularly preferably equal to or less than 240 degrees centigrade.

When the conductive connecting material 30 is heated at the temperature as described above, the metal layer 110 is melted and the melted metal layer 110 can move in the resin layer 120 composed of the curable resin composition. The melted metal layer 110 is aggregated on the terminals 11 and 21 due to its wettability. Thus, as shown in Fig. 3, a conductive portion 130 is formed between the aforementioned terminals, and therefore the terminals 11 and 21 are electrically connected. Herein, aggregation on the terminals means that the area of the metal layer 110 in a planar view is enlarged or reduced than the original area, and also means that the metal layer 110 moves onto the terminals 11 and 21 so as to have an excellent shape for connecting the terminals 11 and 21. Accordingly, it involves the case where the area of the metal layer 110 in a planar view is reduced and the case where it is enlarged. On the other hand, the periphery of the conductive portion 130 is filled with the curable resin composition to form an insulating area 140. As a result, the insulation properties between adjacent terminals can be ensured and shorting circuit between adjacent terminals can be prevented. That is, the conductive connecting material 30 is come into contact with the plurality of terminals 11 and 21, which is subjected to heating, thus to have anisotropic conductivity.

When the curable resin composition contains a compound having a flux function, by the reduction of the compound having a flux function contained in the curable resin composition, the oxide layer on the surface of metal layer 110 is removed, and therefore the wettability of the metal layer 110 is improved and metal binding is promoted to facilitate aggregation between opposed terminals. On the other hand, by the reduction of the compound having a flux function, oxide layers on surfaces of terminals 11 and 21 are also removed to improve wettability. Therefore, metal binding with the metal layer 110 is facilitated.

In the first method for producing an electronic component according to the present invention, heating may be performed under pressure such that the distance between opposed terminals is reduced. For example, by heating and pressurizing in the direction in which the substrate 10 is opposed to the substrate 20 in Fig. 2 using a means such as a publicly known thermal compression bonding apparatus, the distance between opposed terminals can be constantly controlled and the electrical connection reliability between opposed terminals can be improved.

In addition, at the time of pressurizing or heating, ultrasonic wave or electric field may be added, or special heating such as laser and electromagnetic induction may be applied.

(c) Curing Step

In the first method for producing an electronic component according to the present invention, after the conductive area 130 and the insulating area 140 are formed in the aforementioned heating step, the curable resin composition is cured to fix the insulating area 140. Thus, the electrical reliability and mechanical connection strength between the terminals can be sufficiently ensured. Particularly in the first method for producing an electronic component according to the present invention, because of the use of a curable resin composition having a high insulation resistance value, the insulation properties of the insulating area can be ensured more sufficiently.

Curing of the curable resin composition can be carried out by heating the conductive connecting material 30. The curing temperature of the conductive connecting material 30 may be suitably set depending on the composition of the curable resin composition, but it is preferably at least 5 degrees centigrade lower than the heating temperature in the aforementioned heating step and particularly preferably at least 10 degrees centigrade lower. Specifically, the curing temperature is preferably equal to or more than 100 degrees centigrade, more preferably equal to or more than 120 degrees centigrade, particularly preferably equal to or more than 130 degrees centigrade and most preferably equal to or more than 150 degrees centigrade. Meanwhile, it is preferably equal to or less than 300 degrees centigrade, more preferably equal to or less than 260 degrees centigrade, particularly preferably equal to or less than 250 degrees centigrade and most preferably equal to or less than 240 degrees centigrade. When the curing temperature is within the aforementioned range, the conductive connecting material 30 is not thermally decomposed and the curable resin composition can be sufficiently cured.

(2) Second Embodiment

Hereinafter, the first method for producing an electronic component according to the second embodiment of the present invention will be described. In the first method for producing an electronic component according to the second embodiment of the present invention, the step of connecting electronic members to each other is carried out by heating the conductive connecting material at a temperature of equal to or more than the melting point of the metal layer and a

temperature at which the resin layer is softened, while the step of curing or solidifying the resin layer is carried out by cooling the conductive connecting material to a temperature at which the resin layer is solidified.

(a) Placement Step

In the case of using the conductive connecting material 30 containing a thermoplastic resin composition and a metal layer 110, it is also possible to place the conductive connecting material 30 in the same manner as in the case of using the conductive connecting material 30 containing a curable resin composition and a metal layer 110.

(b) Heating Step

The heating step is not particularly limited, but the conductive connecting material 30 placed between the terminals in the aforementioned placement step is heated at a temperature of equal to or more than the melting point of the metal layer 110. The heating temperature is preferably equal to or more than 5 degrees centigrade higher than the melting point of the metal layer, more preferably equal to or more than 10 degrees centigrade higher, further preferably equal to or more than 20 degrees centigrade higher and particularly preferably equal to or more than 30 degrees centigrade higher. The upper limit of the heating temperature is not particularly limited as long as the heating temperature is equal to or more than the melting point of the metal layer 110, and the temperature is within a range in which the resin layer 120 composed of the thermoplastic resin composition is softened and therefore the metal layer 110 can move in the resin layer 120 composed of the thermoplastic resin, that is, the resin layer 120 composed of the thermoplastic resin composition is softened.

The heating temperature may be suitably selected depending on the compositions of the metal layer and the thermoplastic resin composition in use. For example, heating can be performed at the same heating temperature as that of the conductive connecting material containing a curable resin composition and a metal layer.

When the conductive connecting material 30 is heated at the temperature as described above, the metal layer 110 is melted and the melted metal layer 110 can move in the resin layer 120 composed of the thermoplastic resin composition. The melted metal layer 110 is aggregated on the terminals 11 and 21 due to its wettability. Thus, as shown in Fig. 3, a conductive portion 130 is formed between the aforementioned terminals, and therefore the terminals 11 and 21 are electrically connected. On the other hand, the periphery of the conductive portion 130 is filled with the thermoplastic resin composition to form an insulating area 140. As a result, the insulation properties between adjacent terminals can be ensured and shorting circuit between adjacent terminals can be prevented. That is, the conductive connecting material 30 is come into contact with the plurality of terminals 11 and 21, which is subjected to heating, thus to have anisotropic conductivity.

When the thermoplastic resin composition contains a compound having a flux function, by the reduction of the compound having a flux function contained in the thermoplastic resin composition, the oxide layer on the surface of metal layer 110 is removed, and therefore the wettability of the metal layer 110 is improved and metal binding is promoted to facilitate aggregation between opposed terminals. On the other hand, by the reduction of the compound having a flux function, oxide layers on surfaces of terminals 11 and 21 are also removed to improve wettability. Therefore, metal binding with the metal layer 110 is facilitated.

(c) Solidifying Step

In the first method for producing an electronic component according to the present invention, after the conductive area 130 and the insulating area 140 are formed in the aforementioned heating step, the thermoplastic resin composition is solidified to fix the insulating area 140. Thus, the electrical reliability and mechanical connection strength between the terminals can be sufficiently ensured.

Solidifying of the thermoplastic resin composition can be carried out by cooling or solidifying the conductive connecting material 30 heated and melted in the aforementioned heating step. Cooling or solidifying of the conductive connecting material 30 may be suitably set depending on the composition of the thermoplastic resin composition and is not particularly limited. A method of utilizing natural cooling may be employed. Alternatively, a method of spraying cold air or the like may also be employed.

The solidifying temperature of the aforementioned thermoplastic resin composition is not particularly limited, but it is preferably lower than the melting point of the metal layer 110. More specifically, the solidifying temperature of the thermoplastic resin composition is preferably equal to or more than 10 degrees centigrade lower than the melting point of the metal layer 110 and particularly preferably equal to or more than 20 degrees centigrade lower. Meanwhile, the solidifying temperature of the thermoplastic resin composition is preferably equal to or more than 50 degrees centigrade, particularly preferably equal to or more than 60 degrees centigrade and further preferably equal to or more than 100 degrees centigrade. When the solidifying temperature of the thermoplastic resin composition is within the above-described range, the conductive portion 130 can be surely formed and the insulating area 140 can have desired heat resistance. Therefore, the insulation properties between adjacent terminals can be ensured and shorting circuit between adjacent terminals can be more surely prevented.

In the first method for producing an electronic component according to the present invention, the conductive connecting material consisting of a resin layer and a metal layer is used. Thus, by heating the conductive connecting material, it is possible to selectively aggregate the metal layer between opposed terminals. As a result, it is possible to electrically connect opposed terminals and to ensure the insulation properties between adjacent terminals. Moreover, it is possible to electrically conduct a plurality of terminals in a fine pitch circuit such as a semiconductor device or the like at one time and to facilitate connection between terminals excellent in reliability.

3. Second Method for Producing Electronic Component

Hereinafter, the second method for producing an electronic component according to the present invention will be described.

The second method for producing an electronic component according to the present invention involves a placement step of bringing the conductive connecting material into contact with a plurality of terminals, a heating step of heating the conductive connecting material to form conductive portions on the plurality of terminals, and a curing/solidifying step of curing or solidifying the resin layer. The second method for producing an electronic component relates to, for example, a method for producing connecting terminals on an electrode of an electronic member using the aforementioned conductive connecting material. In this case, the aforementioned terminals are, for example, electrodes. Furthermore, the aforementioned conductive portions are, for example, connecting terminals. The second method for producing an electronic component according to the present invention can be used, for example, at the time of producing connecting terminals on an electrode of a semiconductor wafer, a semiconductor chip, a rigid substrate, a flexible substrate and other electronic components.

In the second method for producing an electronic component according to the present invention, production steps for connecting terminals when the resin composition of the conductive connecting material is a curable resin composition are slightly different from production steps for connecting terminals when the resin composition is a thermoplastic resin composition. Hereinafter, the case where the resin composition of the conductive connecting material is a curable resin composition is designated as the first embodiment, the case where the resin composition is a thermoplastic resin composition is designated as the second embodiment, and these embodiments will be described independently.

(1) First Embodiment

In the second method for producing an electronic component according to the first embodiment of the present invention, the step of forming conductive portions is carried out by heating the conductive connecting material at a temperature of equal to or more than the melting point of the metal layer and a temperature at which curing of the resin layer is not completed, while the step of curing or solidifying the resin layer is carried out by heating the conductive connecting material at a temperature at which curing of the resin layer is completed.

In this second method for producing an electronic component, it is possible to selectively aggregate the heated and melted metal layer on the electrode on the substrate to form a connecting terminal, and to form an insulating area by the curable resin composition around the connecting terminal. As a result, the periphery of the connecting terminal is covered with the curable resin composition, and therefore the conductive area is fixed. In addition, since the insulation properties between adjacent connecting terminals are ensured by the insulating area, the connection reliability can be improved. According to this method, it is possible to produce a plurality of connecting terminals in a fine pitch circuit at one time and to facilitate formation of the connecting terminals on the electrode.

Hereinafter, the second method for producing an electronic component according to the first embodiment of the present invention will be described in detail with reference to the drawings. However, the second method for producing an electronic component according to the present invention is not limited to the drawings.

(a) Placement Step

First, as shown in Fig. 5, a conductive connecting material 50 having a resin layer 120 composed of a curable resin composition and a metal layer 110 is placed on a substrate 40 on which a plurality of electrodes 41 are provided. In this case, when a metal layer 110 in a pattern is used, the conductive connecting material 50 and the electrodes 41 on the substrate 40 must be subjected to position adjustment. In Fig. 5, the resin layer 120 composed of the curable resin composition formed on one of the surfaces of the metal layer 110 is used, but the resin layer 120 composed of the curable resin composition may be formed on both surfaces of the metal layer 110. Furthermore, in Fig. 5, the conductive

connecting material 50 is placed such that the resin layer 120 composed of the curable resin composition is opposed to the electrodes 41, but it is also possible to place the conductive connecting material 50 such that the metal layer 110 is opposed to the electrodes 41.
As shown in Fig. 5, the conductive connecting material 50 may be bonded to the substrate 40 by thermal compression using a roll laminator, a pressing apparatus or the like. In Fig. 6, the electrodes 41 are covered with the resin layer 120 composed of the curable resin composition, but the thickness of the resin layer 120 composed of the thermosetting resin composition may be smaller or larger than the thickness of the electrode 41 and may be suitably adjusted depending on purposes and applications. In addition, the surface of the electrode 41 may be subjected to treatments such as washing, polishing, plating and surface activation in order to provide good electrical connection or to improve adhesion properties with the metal layer 110, as necessary.

(b) Heating Step

In the heating step, the conductive connecting material 50 placed on the electrodes 41 on the substrate 40 in the aforementioned placement step is heated at a temperature of equal to or more than the melting point of the metal layer 110 and a temperature at which curing of the curable resin composition is not completed. Thus, as shown in Fig. 7, a connecting terminal 150 can be formed on the electrode 41. On the other hand, the periphery of the connecting terminal 150 is filled with the curable resin composition to form an insulating area 140. As a result, the insulation properties between adjacent connecting terminals 150 can be ensured and shorting circuit between adjacent connecting terminals 150 can be prevented.
The heating temperature and pressurization conditions of the curable resin composition may be the same as those in the case where terminals are connected using the aforementioned conductive connecting material having a curable resin composition and a metal layer in the first method for producing an electronic component.

(c) Curing Step

In the curing step, after the connecting terminal 150 and the insulating area 140 are formed in the aforementioned heating step, the curable resin composition is cured to fix the insulating area 140. Thus, adhesion between the electrode 41 on the substrate 40 and the connecting terminal 150 can be reinforced. Particularly in the first embodiment of the present invention, because of the use of a curable resin composition having a high insulation resistance value, the insulation properties of the insulating area can be ensured more sufficiently. Though there is no particular limitation, the curing step is preferably carried out after the connecting terminal 150 is formed and a substrate 60 is mounted on another electronic component or substrate to be connected.
The heating temperature of the conductive connecting material in the curing step may be the same as that in the case where terminals are connected using the conductive connecting material having a curable resin composition and a metal layer in the first method for producing an electronic component.

(2) Second Embodiment

Hereinafter, the second method for producing an electronic component according to the second embodiment of the present invention will be described.
In the second method for producing an electronic component according to the second embodiment of the present invention, the step of forming conductive portions is carried out by heating the conductive connecting material at a temperature of equal to or more than the melting point of the metal layer and a temperature at which the resin layer is softened, while the step of curing or solidifying the resin layer is carried out by cooling the conductive connecting material to a temperature at which the resin layer is solidified.
In the production method of the second embodiment, it is possible to selectively aggregate the heated and melted metal layer on the electrode on the substrate to form a connecting terminal, and to form an insulating area by the thermoplastic resin composition around the connecting terminal. As a result, the periphery of the connecting terminal is covered with the thermoplastic resin composition, and therefore the conductive area is fixed. In addition, since the insulation properties between adjacent connecting terminals are ensured by the insulating area, the connection reliability can be improved. According to this method, it is possible to produce a plurality of connecting terminals in a fine pitch circuit at one time.

(a) Placement Step

In the case of using the conductive connecting material containing a thermoplastic resin composition and a metal layer, it is also possible to place the conductive connecting material on a substrate on which electrodes are placed in the same manner as in the case of using the conductive connecting material containing a curable resin composition

and a metal layer of the first embodiment.

(b) Heating Step

In the heating step, the conductive connecting material 50 placed on the electrode provided on the substrate in the aforementioned placement step is heated at a temperature of equal to or more than the melting point of the metal layer 110 and a temperature at which the resin layer 120 composed of the thermoplastic resin composition is softened. Thus, in the same manner as in the first embodiment, the connecting terminal 150 can be prepared on the electrode 41. On the other hand, the periphery of the connecting terminal 150 is filled with the thermoplastic resin composition to form an insulating area 140. As a result, the insulation properties between adjacent connecting terminals 150 can be ensured and shorting circuit between adjacent connecting terminals 150 can be prevented.
The heating temperature and pressurization conditions of the thermoplastic resin composition may be the same as those in the case where terminals are connected using the aforementioned conductive connecting material having the thermoplastic resin composition and the metal foil in the first method for producing an electronic component.

(c) Solidifying Step

In the solidifying step, after the connecting terminal 150 and the insulating area 140 are formed in the aforementioned heating step, the thermoplastic resin composition is cooled and solidified to fix the insulating area 140. Thus, adhesion between the electrode 41 and the connecting terminal 150 can be reinforced.
A cooling method and a preferable solidifying temperature of the thermoplastic resin composition are the same as those in the case where terminals are connected using the aforementioned conductive connecting material having the thermoplastic resin composition and the metal layer in the first method for producing an electronic component.
As described above, in the second method for producing an electronic component according to the present invention, by the use of the conductive connecting material of the present invention, the metal layer can be selectively aggregated to a region at which the connecting terminal is formed, and therefore the connecting terminal can be produced using a simple method. According to the second method for producing an electronic component of the present invention, it is possible to produce a plurality of connecting terminals in a fine pitch circuit such as a semiconductor device or the like at one time. In addition, insulating areas can be formed in the periphery of the plurality of connecting terminals, so that the connecting terminals can be fixed and the insulation properties between adjacent connecting terminals can be ensured. Therefore, it is possible to facilitate production of connecting terminals having excellent connection reliability.

4. Electronic Member with Conductive Connecting Material and Electronic Component

The present invention also includes an electronic member with a conductive connecting material, in which the conductive connecting material of the present invention is attached to an electrical connection surface of the electronic member on which a plurality of terminals are formed. In the electronic member with the conductive connecting material of the present invention, the surface of the conductive connecting material to adhere to the electrical connection surface of the electronic member is preferably a resin layer. The resin layer may be directly attached to the electrical connection surface of the electronic member or may be attached via an adhesive layer. By bonding the electronic members with the conductive connecting material of the present invention to each other or by bonding the electronic member with the conductive connecting material of the present invention to an electrical connection surface of another type of electronic member to be subjected to thermal compression bonding, such electronic members can be electrically connected to each other.
The present invention also includes semiconductor wafers, semiconductor chips, rigid substrates, flexible substrates and other electronic components, in which electronic members are electrically connected using the conductive connecting material of the present invention obtained in the above-described way.

EXAMPLES

The present invention is now illustrated below with reference to Examples. However, the present invention is not restricted to the following Examples.

Examples 1 to 7

(1) Production of Curable Resin Composition

Respective components described in Table 1 were dissolved in methyl ethyl ketone (MEK) to obtain a varnish

of a resin composition having 40% of a resin solid content. The resulting varnish was coated on a polyester sheet using a comma coater and dried at 90 degrees centigrade for 5 minutes to obtain a curable resin composition in a film form having a thickness of 30 μm.

(2) Measurement of coefficient of thermal expansion of Resin Composition

The curable resin composition obtained in (1) was cured at a temperature of 180 degrees centigrade for 1 hour to obtain a sample. The sample was used for the measurement of the coefficient of thermal expansion of the resin composition under the conditions of a temperature increase rate of 10 degrees centigrade/min and a load of 50 mN in a tensile stress method using a thermo-mechanical analysis apparatus (TMA, SS6100, commercially available from Seiko Instruments Inc.). The average value of the coefficient of thermal expansion at from room temperature to 100 degrees centigrade was taken as a measurement value.

(3) Production of Conductive Connecting Material

The obtained curable resin composition in a film form was laminated on both surfaces of the solder foil described in Table 1 under the conditions of 60 degrees centigrade, 2 $kgf/cm^2$ and 0.3 m/min to produce a conductive connecting material having a thickness of 70 μm.

(4) Connection Between Terminals

Next, terminals on substrates were connected to each other using the obtained conductive connecting material. Two substrates composed of an FR-4 base material (thickness: 0.1 mm) and a circuit layer (copper circuit, thickness: 12 μm) and having connecting terminals (terminal diameter: 100 μm, center distance between adjacent terminals: 200 μm) formed by applying Ni/Au plating (thickness: 3 μm) on the copper circuit, were prepared and used for connection. The aforementioned conductive connecting material was placed between such substrates having connecting terminals, and using a thermal compression bonding apparatus (TMV1-200ASB, commercially available from Tsukuba Mechanics Co., Ltd.), thermal compression bonding (gap between substrates: 50 μm) was applied under the conditions of 230 degrees centigrade, 0.5 MPa and 120 seconds to connect the terminals. Thereafter, the curable resin composition was cured by heating at 180 degrees centigrade for 1 hour to obtain a laminate.

Comparative Example 1

A curable resin composition without containing a filler was prepared in the same manner as in Example 1, and the obtained curable resin composition having a thickness of 30 μm was laminated on both surfaces of the solder foil described in Table 1 to produce a conductive connecting material having a thickness of 70 μm. Furthermore, terminals on a substrate were connected to each other using the obtained conductive connecting material in the same method as in Example 1 (method described in the aforementioned (4) Connection Between Terminals).

In the laminate obtained in each of Examples and Comparative Examples, connection resistance between opposed terminals, formability of conducting path between opposed terminals and electrical resistance after a heat cycle test were evaluated using the method described below.

[1] Connection Resistance Between Opposed Terminals

The connection resistance between opposed terminals in the laminate obtained in each of Examples and Comparative Examples was measured at 12 points using the four-terminal method (resistance meter: digital multi-meter VOA7510, commercially available from Iwatsu Electric Co., Ltd., measurement probe: pin-type lead 9771, commercially available from Hioki E. E. Corporation), and it was judged as follows: "A" when the average value was less than 30 mΩ; and "B" when the average value was equal to or more than 30 mΩ.

[2] Formability of Conducting Path Between Opposed Terminals

Regarding 10 pairs of opposed terminals in the laminate obtained in each of Examples and Comparative Examples, the cross-section between the terminals was observed using a scanning electron microscope (SEM) (JSM-7401F, commercially available from JEOL Ltd.), and it was judged as follows: "A" when a cylindrical conducting path was formed by solder in all the 10 pairs; "B" when no conducting path was formed in at least one pair of terminals; and "C" when shorting circuit occurred between adjacent terminals.

[3] Electrical Resistance after Heat Cycle Test

The connection resistance between opposed terminals in the laminate obtained in each of Examples and Comparative Examples was measured at 12 points using the four-terminal method (resistance meter: digital multi-meter VOA7510, commercially available from Iwatsu Electric Co., Ltd., measurement probe: pin-type lead 9771, commercially available from Hioki E. E. Corporation). Next, the laminate was subjected to a heat cycle test for 1,000 cycles and 1,500 cycles (one cycle was carried out at -40 degrees centigrade for 10 minutes and at 85 degrees centigrade for 10 minutes), and the connection resistance between terminals was measured in the same manner as described above.
It was judged as follows: "A" when the change from the initial value of the connection resistance in all points was less than 15% with no visible damage; "B" when the change from the initial value of the connection resistance was equal to or more than ±5% and less than ±10% with no visible damage; and "C" when its appearance was swollen after the heat cycle test, peeling was observed or the like, or the change from the initial value of the connection resistance was equal to or more than ±10%.

[4] Water Absorption Ratio

The water absorption ratio WA [%] of the resin layer having the conductive connecting material obtained in each of Examples and Comparative Examples was determined in the following manner. First, the resin layer having the produced conductive connecting material was cured and dried under the conditions of a temperature of 180 degrees centigrade and 1 hour. Then, immediately the weight $W_0$[g] of the resin layer was measured. Next, the weight $W_1$ [g] of the resin layer was measured after the conductive connecting material was placed under the atmosphere of a temperature of 85 degrees centigrade and a humidity of 85%RH for 24 hours. The water absorption ratio WA [%] was determined from the measured $W_0$[g] and $W_1$[g] using the following formula.

$$WA[\%] = (W_1 - W_0) / W_0 \times 100$$

The results are shown in Table 1.

[Table 1]

| | | | | Example 1 | Example 2 | Example 3 | Example 4 |
|---|---|---|---|---|---|---|---|
| Formulation [parts by weight] | Resin layer | Epoxy resin | | 32.0 | 23.9 | 15.9 | 23.9 |
| | | Curing agent | | 20.0 | 14.9 | 9.9 | 14.9 |
| | | Film forming resin | | 24.0 | 17.9 | 11.9 | 17.9 |
| | | Compound having a flux function 1 Sebacic acid | | 3.6 | 2.7 | 1.8 | 2.7 |
| | | Compound having a flux function 2 Phenolphthalin | | | | | |
| | | Silane coupling agent | | 0.49 | 0.49 | 0.490 | 0.49 |
| | | Antioxidant | | | | | |
| | | Imidazole | | 0.01 | 0.01 | 0.01 | 0.01 |
| | | Filler 1 Silica | | 20.00 | 40.00 | 60.00 | |
| | | Filler 2 Alumina | | | | | 40.00 |
| | | Total | | 100.0 | 100.0 | 100.0 | 100.0 |
| | Metal layer | Metal layer A Sn-3Ag-0.5Cu | | o | o | o | o |
| | | Metal layer B Sn-37Pb | | | | | |
| Results of evaluation | coefficient of thermal expansion of resin composition [ppm] | | | 66 | 58 | 32 | 70 |
| | Fv/Mv | | | 0.61 | 1.40 | 2.43 | 0.90 |
| | Connection resistance between opposed terminals | | Not treated | A | A | A | A |
| | Formability of conducting path between opposed terminals | | Not treated | A | A | A | A |
| | Connection resistance after heat cycle test | | After 1,000 cycles | A | A | A | A |
| | | | After 1,500 cycles | A | A | A | A |
| | Water absorption ratio [%] | | | 1.1 | 0.8 | 0.5 | 0.7 |

[Table 1] (continued)

| | | | | Example 5 | Example 6 | Example 7 | Comp. Example 1 |
|---|---|---|---|---|---|---|---|
| Formulation [parts by weight] | Resin layer | Epoxy resin | | 23.9 | 23.9 | 7.8 | 40.0 |
| | | Curing agent | | 14.9 | 11.7 | 4.9 | 25.0 |
| | | Film forming resin | | 17.9 | 17.9 | 5.9 | 30.0 |
| | | Compound having a flux function 1 Sebacic acid | | 2.7 | | 0.9 | 4.5 |
| | | Compound having a flux function 2 Phenolphthalin | | | 6.0 | | |
| | | Silane coupling agent | | 0.49 | 0.49 | 0.49 | 0.49 |
| | | Antioxidant | | | | | |
| | | Imidazole | | 0.01 | 0.01 | 0.01 | 0.01 |
| | | Filler 1 Silica | | 40.00 | 40.00 | 80.00 | |
| | | Filler 2 Alumina | | | | | |
| | | Total | | 100.0 | 100.0 | 100.0 | 100.0 |
| | Metal layer | Metal layer A Sn-3Ag-0.5Cu | | | o | o | o |
| | | Metal layer B Sn-37Pb | | o | | | |
| Results of evaluation | coefficient of thermal expansion of resin composition [ppm] | | | 58 | 55 | 28 | 75 |
| | Fv/Mv | | | 1.40 | 1.40 | 3.87 | - |
| | Connection resistance between opposed terminals | | Not treated | A | A | A | A |
| | Formability of conducting path between opposed terminals | | Not treated | A | A | A | A |
| | Connection resistance after heat cycle test | | After 1,000 cycles | A | A | A | A |
| | | | After 1,500 cycles | A | A | A | B |
| | Water absorption ratio [%] | | | 0.8 | 0.7 | 0.3 | 1.5 |

The following products were used for the components of the resin layer and the metal layer in Table 1. Epoxy resin: A bisphenol A type epoxy resin, "EPICLON-840S," commercially available from DIC Corporation, epoxy equivalent: 185 g/eq

Curing agent: Phenol novolac, "PR-53647," commercially available from Sumitomo Bakelite Co., Ltd.

Film forming resin: A modified biphenol type phenoxy resin, "YX-6954," commercially available from Japan Epoxy Resins Co., Ltd., weight average molecular weight: 39,000

Compound having a flux function 1: Sebacic acid, "Sebacic Acid, commercially available from Tokyo Chemical Industry Co., Ltd.

Compound having a flux function 2: Phenolphthalin, "Phenolphthalin," commercially available from Tokyo Chemical Industry Co., Ltd.
Silane coupling agent: 2-(3,4-epoxycyclohexyl)ethyltrimethoxysilane, "KBM-303," commercially available from Shin-Etsu Chemical Co., Ltd.
Imidazole: 2-phenyl-4-methylimidazole, "CUREZOL 2P4MZ," commercially available from Shikoku Chemicals Corporation
Filler 1: Silica, "SE2050," commercially available from Admatechs Co., Ltd., average particle diameter: 0.5 μm, specific gravity: 2.2
Filler 2: Alumina, "AS-50," commercially available from Showa Denko Kabushiki Kaisha, average particle diameter: 9 μm, specific gravity: 3.8
Metal layer A: Sn/Pb=63/37 (melting point: 183 degrees centigrade) thickness: 10 μm
Metal layer B: Sn/Ag/Cu=96.5/3.0/0.5 (melting point: 217 degrees centigrade) thickness: 10 μm

As apparent from the results shown in Table 1, with the use of the resin layer containing a resin component and a filler as the resin layer of the conductive connecting material, the coefficient of thermal expansion of the resin layer after curing was lowered, the stress applied to a connection portion caused by thermal expansion due to heating upon mounting of components or a heat cycle test was reduced, and the reliability of the electronic component was improved. Furthermore, with the use of a resin layer containing a filler as the resin layer of the conductive connecting material, the amount of moisture absorption or water absorption of the resin layer after curing was reduced, and heat resistance under moisture absorption of the electronic component was improved.

This application is based on Japanese patent application No. 2009-292706 filed on December 24, 2009, the content of which is incorporated hereinto by reference.

INDUSTRIAL APPLICABILITY

The conductive connecting material of the present invention can be suitably used at the time of electrically connecting electronic members in an electronic component or producing connecting terminals on a substrate. With the use of the conductive connecting material of the present invention, excellent electrical connection and high insulation reliability between electronic members can be combined. With the use of the conductive connecting material of the present invention, it is also possible to connect terminals in a fine pitch circuit. With the use of the conductive connecting material of the present invention, it is also possible to cope with the requirements of higher functionality and reduction in a size of electronic devices.

**Claims**

1. A conductive connecting material used to form conductive portions on a plurality of terminals of an electronic member having a substrate and the plurality of terminals provided on said substrate, comprising
a metal layer, and
a resin layer having a resin component and a filler, wherein said metal layer is aggregated on each of terminals to form said conductive portions on said plurality of terminals by bringing the conductive connecting material into contact with said plurality of terminals and heating the conductive connecting material.

2. The conductive connecting material according to claim 1, wherein said metal layer is separated to aggregate on each of terminals by bringing the conductive connecting material into contact with said plurality of terminals and heating the conductive connecting material.

3. The conductive connecting material according to claim 1 or 2, wherein other resin layer is provided on a surface of said metal layer opposite to a surface of said metal layer on which said resin layer is formed.

4. The conductive connecting material according to any one of claims 1 to 3, wherein said metal layer is composed of solder or tin.

5. The conductive connecting material according to any one of claims 1 to 4, wherein the particle diameter of said filler is from 10 nm to 50 μm.

6. The conductive connecting material according to any one of claims 1 to 5, wherein the content of said filler is from 1 to 80% by weight, based on the total weight of said resin layer.

**7.** The conductive connecting material according to any one of claims 1 to 6, wherein, when the volume of said filler is Fv and the volume of said metal layer is Mv, Fv/Mv is from 0.01 to 10.

**8.** The conductive connecting material according to any one of claims 1 to 7, wherein the coefficient of thermal expansion of said resin layer at from room temperature to 100 degrees centigrade is from 3 to 70 ppm.

**9.** The conductive connecting material according to any one of claims 1 to 8, wherein said resin layer contains a compound having a flux function.

**10.** The conductive connecting material according to claim 9, wherein said compound having a flux function has a phenolic hydroxyl group and/or a carboxyl group.

**11.** The conductive connecting material according to claim 9 or 10, wherein said compound having a flux function contains a compound represented by the following general formula (1),

$$HOOC-(CH_2)_n-COOH \qquad (1)$$

wherein, in the formula, n is an integer of from 1 to 20.

**12.** The conductive connecting material according to claim 9 or 10, wherein said compound having a flux function contains a compound represented by the following general formula (2) and/or (3),

[Chemical Formula 1]

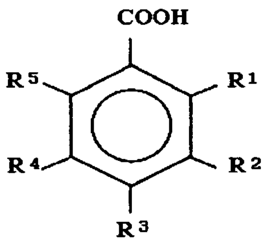

(2)

wherein, in the formula, $R^1$ to $R^5$ are each independently a monovalent organic group; and at least one of $R^1$ to $R^5$ is a hydroxyl group,

[Chemical Formula 2]

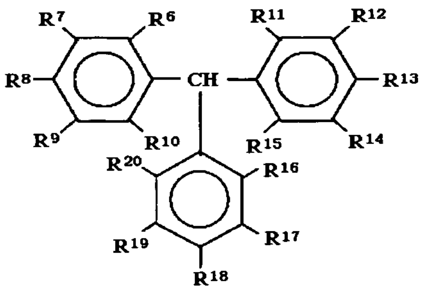

(3)

wherein, in the formula, $R^6$ to $R^{20}$ are each independently a monovalent organic group; and at least one of $R^6$ to $R^{20}$ is a hydroxyl group or a carboxyl group.

**13.** The conductive connecting material according to any one of claims 1 to 12, wherein the melting point of said metal layer is from 100 to 330 degrees centigrade.

**14.** The conductive connecting material according to any one of claims 1 to 13, wherein said terminals are electrodes

and said conductive portions are connecting terminals.

**15.** A method for producing an electronic component comprising
a step of placing the conductive connecting material according to any one of claims 1 to 13 between said two electronic members opposed to each other with said plurality of terminals facing towards the inside and bringing the conductive connecting material into contact with said plurality of terminals of each of said two electronic members;
a step of heating said conductive connecting material and connecting said plurality of terminals of each of said two electronic members to each other through said conductive portions formed on said plurality of terminals; and
a step of curing or solidifying said resin layer.

**16.** The method for producing an electronic component according to claim 15, in which said resin layer has a thermosetting resin,
the step of connecting said electronic members to each other is carried out by heating said conductive connecting material at a temperature of equal to or more than the melting point of said metal layer and a temperature at which curing of said resin layer is not completed, and
the step of curing or solidifying said resin layer is carried out by heating said conductive connecting material at a temperature at which curing of said resin layer is completed.

**17.** The method for producing an electronic component according to claim 15, in which said resin layer has a thermoplastic resin,
the step of connecting said electronic members to each other is carried out by heating said conductive connecting material at a temperature of equal to or more than the melting point of said metal layer and a temperature at which said resin layer is softened, and
the step of curing or solidifying said resin layer is carried out by cooling said conductive connecting material to a temperature at which said resin layer is solidified.

**18.** A method for producing an electronic component comprising
a step of bringing the conductive connecting material according to claim 14 into contact with said plurality of terminals;
a step of heating said conductive connecting material to form said conductive portions on said plurality of terminals; and
a step of curing or solidifying said resin layer.

**19.** The method for producing an electronic component according to claim 18, in which said resin layer has a thermosetting resin,
the step of forming said conductive portions is carried out by heating said conductive connecting material at a temperature of equal to or more than the melting point of said metal layer and a temperature at which curing of said resin layer is not completed, and
the step of curing or solidifying said resin layer is carried out by heating said conductive connecting material at a temperature at which curing of said resin layer is completed.

**20.** The method for producing an electronic component according to claim 18, in which said resin layer has a thermoplastic resin,
the step of forming said conductive portions is carried out by heating said conductive connecting material at a temperature of equal to or more than the melting point of said metal layer and a temperature at which said resin layer is softened, and
the step of curing or solidifying said resin layer is carried out by cooling said conductive connecting material to a temperature at which said resin layer is solidified.

**21.** An electronic member with a conductive connecting material, wherein the conductive connecting material according to any one of claims 1 to 14 is attached to said substrate of said electronic member so as to contact with said plurality of terminals.

**22.** An electronic component, wherein said plurality of terminals of each of said two electronic members opposed to each other with said plurality of terminals facing towards the inside are connected to each other through said conductive portions formed using the conductive connecting material according to any one of claims 1 to 14.

Fig.1

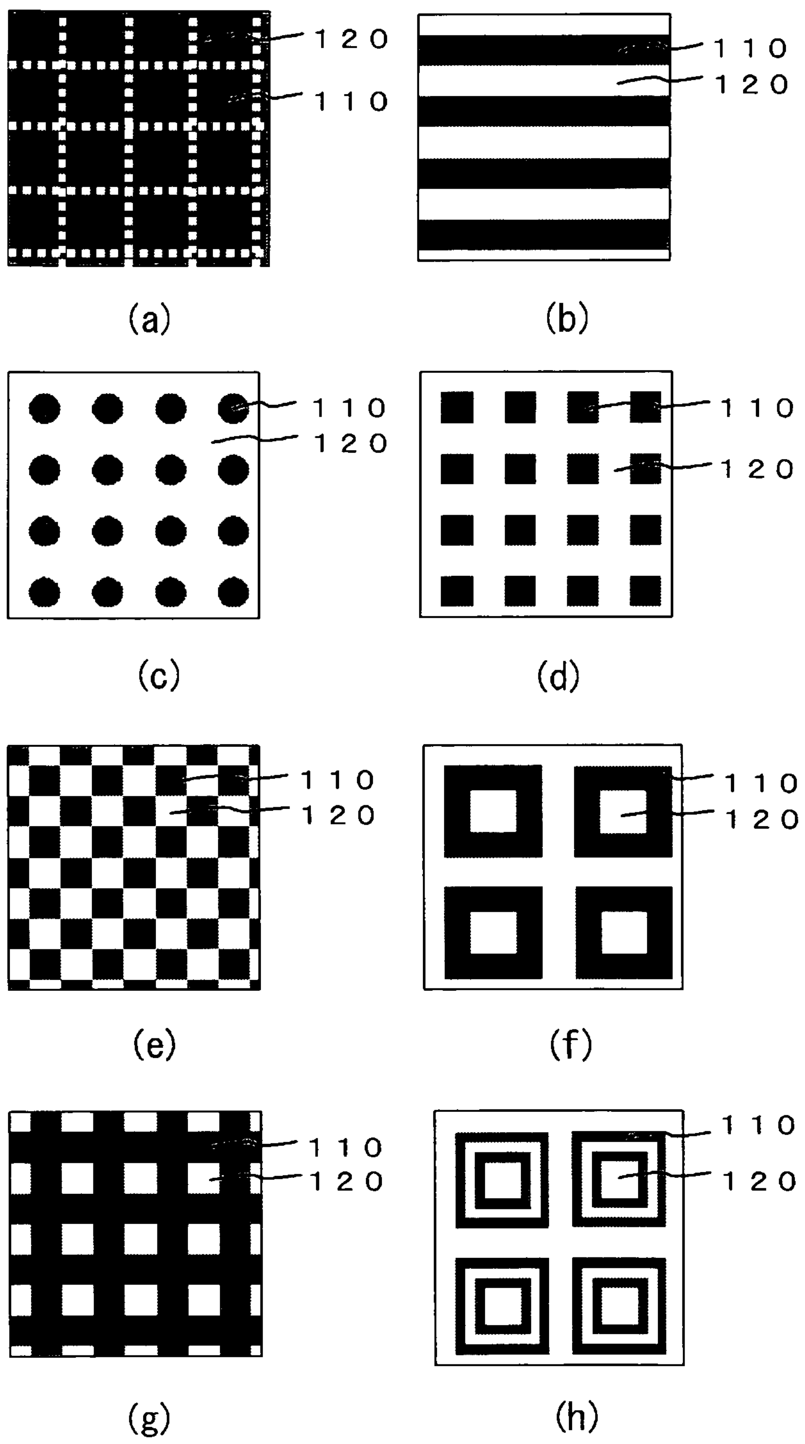
120
110
(a)
110
120
(b)
110
120
(c)
110
120
(d)
110
120
(e)
110
120
(f)
110
120
(g)
110
120
(h)

Fig.2

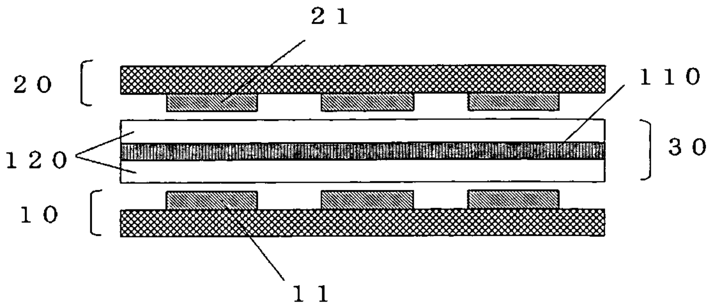


Fig.3

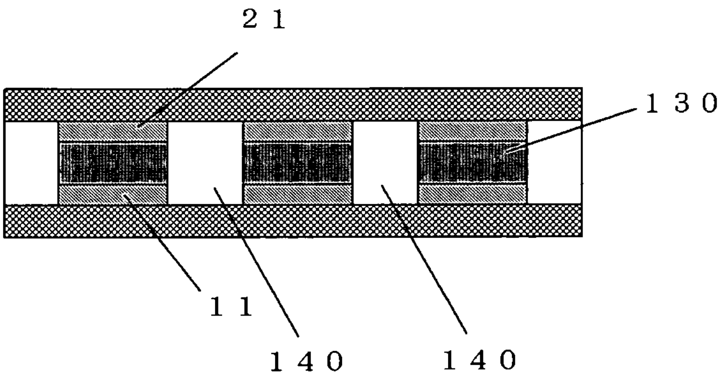


Fig.4

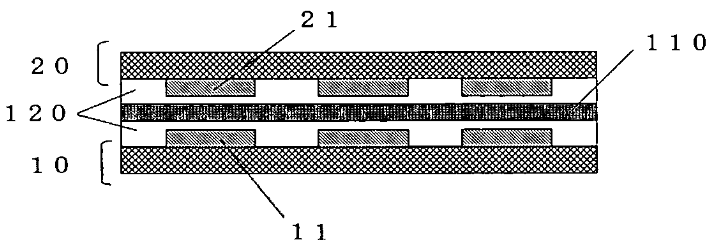


Fig.5

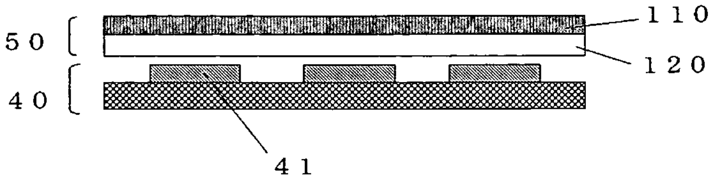


Fig.6

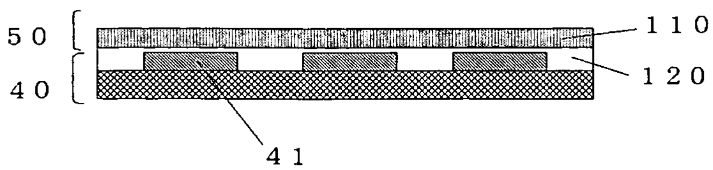

Fig.7

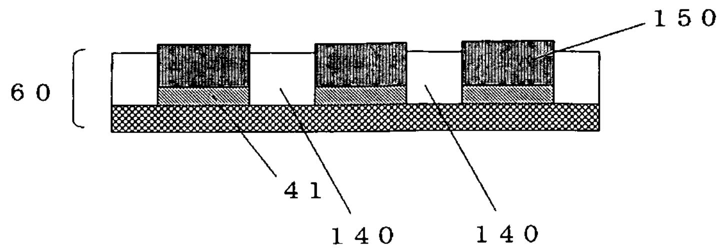

**INTERNATIONAL SEARCH REPORT**

International application No.
PCT/JP2010/007323

A. CLASSIFICATION OF SUBJECT MATTER
*H05K3/34*(2006.01)i, *C09J9/02*(2006.01)i, *H01B5/02*(2006.01)i, *H01L21/60*(2006.01)i, *H01R11/01*(2006.01)i, *H01R43/00*(2006.01)i

According to International Patent Classification (IPC) or to both national classification and IPC

B. FIELDS SEARCHED

Minimum documentation searched (classification system followed by classification symbols)
H05K3/34, C09J9/02, H01B5/02, H01L21/60, H01R11/01, H01R43/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-203693 A (Mitsubishi Electric Corp.), 28 July 2005 (28.07.2005), paragraphs [0018], [0024]; fig. 1 (Family: none) | 1-22 |
| A | JP 2000-332393 A (Sumitomo Bakelite Co., Ltd.), 30 November 2000 (30.11.2000), paragraphs [0011] to [0026], [0030], [0035], [0037] (Family: none) | 1-22 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>15 March, 2011 (15.03.11) | Date of mailing of the international search report<br>22 March, 2011 (22.03.11) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2010/007323

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-260131 A (Japan Science and Technology Agency), 16 September 2004 (16.09.2004), paragraphs [0088] to [0096]; fig. 12 & US 2007/0001313 A1 & EP 1615263 A1 & WO 2004/070827 A1 & KR 10-2005-0094478 A & CN 1820361 A | 1-22 |
| A | JP 2008-111990 A (Sumitomo Bakelite Co., Ltd.), 15 May 2008 (15.05.2008), paragraphs [0048] to [0051] (Family: none) | 10-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP S61276873 B
- JP 2004260131 A
- JP 2009292706 A